# EUROPÄISCHE PATENTSCHRIFT

(11) **EP 3 514 709 B1**
(45) Veröffentlichungstag und Bekanntmachung des Hinweises auf die Patenterteilung: **07.06.2023**
(21) Anmeldenummer: 19020039.4
(22) Anmeldetag: 21.01.2019
(51) Int. Cl.: G06F 16/58, G06F 16/51, G06F 16/56

(54) **VERFAHREN UND VORRICHTUNG ZUR ÜBERTRAGUNG UND ANZEIGE VON NUTZEREIGENEN VEKTORGRAPHIKEN MIT INFOPUNKTEN AUS EINEM CLOUDBASIERTEN CAD-ARCHIV AUF MOBILGERÄTEN, TRAGBAREN ODER STATIONÄREN COMPUTERN**
METHOD AND APPARATUS FOR TRANSMITTING AND DISPLAYING USER VECTOR GRAPHICS WITH INFO ITEMS FROM A CLOUD-BASED CAD ARCHIVE ON MOBILE DEVICES, MOBILE OR STATIONARY COMPUTERS
PROCÉDÉ EN APPAREIL DE TRANSMISSION ET D'AFFICHAGE DES GRAPHIQUES VECTORIELS PROPRIÉTAIRES COMPORTANT DES POINTS D'INFORMATION , À PARTIR D'UNE ARCHIVE CAD FONDÉ SUR L'INFONUAGIQUE, SUR LES APPAREILS MOBILES, LES ORDINATEURS PORTABLES OU FIXES

(30) Priorität: 22.01.2018 DE 102018000459
(43) Veröffentlichungstag der Anmeldung: 24.07.2019
(73) Patentinhaber: Becker, Joachim, 07747 Jena (DE)
(72) Erfinder: Becker, Joachim, D-07747 Jena (DE)
(74) Vertreter: Dreykorn-Lindner, Werner

(56) Entgegenhaltungen:
- CN-A- 107 402 928
- Anonymous: "Dropbox", , 12. Januar 2018 (2018-01-12), Seiten 1-3, XP055605658, Gefunden im Internet: URL:https://de.wikipedia.org/w/index.php?t itle=Dropbox&oldid=172850938 [gefunden am 2019-07-16]
- Anonymous: "SVG to PNG", , 1. Oktober 2013 (2013-10-01), Seiten 1-2, XP055605808, Gefunden im Internet: URL:http://web.archive.org/web/20131001014 031/https://www.zamzar.com/convert/svg-to- png/ [gefunden am 2019-07-16]

## Beschreibung

Die Erfindung betrifft, gemäß Patentanspruch 1, ein Verfahren zur Übertragung und Anzeige von nutzereigenen Vektorgraphiken mit Infopunkten aus einem cloudbasierten CAD-Archiv auf Mobilgeräten, tragbaren oder stationären sowie eine entsprechende Vorrichtung nach Patentanspruch 15.

Die Sammlung von Geodaten und darauf basierende Kartendienste sind seit mehr als einem Jahrzehnt bekannt. Solche Dienste sind beispielsweise Google Maps, Google Earth mit Teilfunktionen wie Google Map Maker (Bearbeitung der Darstellungen von Google Maps durch Nutzer, beispielsweise Umrisse von Gebäuden zeichnen oder zusätzliche Straßen kennzeichnen), Google Street View (Ansichten in 360°-Panoramabildern aus der Straßenperspektive), Google Maps Indoor (automatische Ansicht aller Gänge und Räume eines Gebäudes beim Unterschreiten einen bestimmten Schwellenwert des Zoomfaktors, wodurch die Navigation innerhalb von großen Gebäuden, wie beispielsweise einem Flughafen, vereinfacht werden soll), Google Transit (Verwendung von Daten über Reiserouten und Preisen von Verkehrsbetrieben zur Routenplanung), OpenStreetMap (OSM) (Sammlung von frei nutzbaren Geodaten durch jedermann in einer Datenbank und Erstellen von Landkarten aus diesen Daten, wobei auf den OpenStreetMap-Daten zahlreiche weitere Dienste und Spezialanwendungen aufbauen), Apple Maps (auf Vektorgrafik basierender Kartendienst zur Darstellung auf einem Mobiltelefon, insbesondere Navigation, Fahrspurassistent, Tempolimit-Anzeige, Indoor-Karten für Gebäude, Reise- und Routenplanung), TomTom-Geodaten für Telemetrie- und Flottenlösungen u.a.

Google bietet eine Programmierschnittstelle (API) für den Nutzer an, mit der dieser Google Maps in seine eigenen Seiten einbinden kann. Die API bietet viele Möglichkeiten, die Karte auf der eigenen Seite des Nutzers zu konfigurieren, beispielsweise kann eine Zoomleiste eingeblendet werden oder es können Marker auf der Darstellung platziert werden. Google stellt hierzu für beliebige Karten auf der Seite von Google Maps einen direkt einbindbaren HTML-Code (Hypertext Markup Language ist eine textbasierte Auszeichnungssprache zur Strukturierung digitaler Dokumente wie Texte mit Hyperlinks, Bildern und anderen Inhalten) zur Verfügung, wobei die Pixel-Abmessungen der Bilder im Code definierbar ist. Auf diesem Weg können mit Google Maps auch größere Karten als in der Standardansicht erstellt werden. Seit März 2017 bietet Google Maps auch die Freigabe des Standortes an ausgewählte Kontakte in Echtzeit an. Dabei kann festgelegt werden, welche Kontakte für eine bestimmbare Zeit den Standort auf der Karte live verfolgen können, wobei die Freigabe automatisch nach Ankunft endet.

Der OpenStreetMap-Datenbank-Server verwendet eine Datenbank, in welcher die durch Abfahren bzw. Ablaufen der Straßen gewonnen GPS-Rohdaten (GPS-Spuren) bzw. Luftbilder und Karten nach Wandlung in Geodaten in Form von Vektordaten mit Zusatzinformationen (Attribute/tags) versehene Linien, Punkte und Flächen (sogenanntes lokales Wissen) gespeichert werden. Jedes Tag besteht aus einem Schlüssel (key) und einem Wert (value). Die Anzahl der Tags pro Element ist theoretisch unbegrenzt, so dass sich über die rein physischen Eigenschaften eine Fülle von Zusatzinformationen abbilden lässt. Sogenannte Relationen verknüpfen Elemente zu größeren Gesamtheiten was beispielsweise das Erfassen von Buslinien ermöglicht. Die meisten Programme zum Editieren und Umwandeln der Daten sind ebenso wie der Quellcode der OpenStreetMap-Website unter freien Softwarelizenzen erhältlich. Der Einsatz von OpenStreetMap-Daten in proprietärer Software ist aber ausdrücklich erlaubt. Insbesondere kann aus den Geodaten in Form von Vektordaten eine Pixelgrafik-Karte (Datei-Endung: PNG (Portable Network Graphics, portable Netzwerkgrafik)) mit Hilfe einer separaten Datenbank und einem sogenannten Renderer (Programm, welches HTML und SVG (Beschreibungssprachen) in eine grafische Bildschirmdarstellung konvertiert), welcher die Karte in Form von Kachelgrafiken berechnet, erzeugt werden, wobei die OSM-Daten bei Änderungen der Rohdaten aktualisiert werden. Um die Rendering-Last zu reduzieren, werden nur die Bereiche der Karte konvertiert, die auch tatsächlich betrachtet wurden. Mit dem Werkzeug Objektabfrage lässt sich das komplette Tagging jedes beliebigen Elements aus der Datenbank anzeigen. Eine gebietsbezogene Abfrage (etwa die Ausgabe aller erfassten Tankstellen, die eine bestimmte Kraftstoffsorte anbieten) ist mit dem Werkzeug Overpass Turbo möglich. Eine weitere Teilfunktion von OpenStreetMap ist die Karte OpenStreetMap-Wikipedia, welche weltweit alle georeferenzierten Wikipedia-Artikel und die zugehörigen Bilder zeigt. Je weiter man hineinzoomt, desto mehr Marker erscheinen. Ein Klick auf einen Marker öffnet ein Fenster, in dem ein Link zum entsprechenden Wikipedia-Artikel gezeigt wird, sowie ein Bild aus der Wikimedia-Bilderdatenbank "Commons". In der Weltkarte aller Wikipedia-Artikel können statt der Marker auch alle Bilder als Miniaturbilder angezeigt werden. Man sieht dann beispielsweise rund um das Brandenburger Tor in Berlin Bilder aus der Umgebung, wobei jedes Bild wieder zum entsprechenden Wikipedia-Artikel verlinkt ist. OpenStreetMap OSM speichert frei verfügbare Geodaten - beispielsweise die Lage und Grundfläche eines Hauses sowie gegebenenfalls allgemeine Angaben wie Anzahl der Stockwerke oder Adresse mit Hausnummer. Die Speicherung der Daten von Privatpersonen oder bei Privatgrundstücken über Gebäude und Zufahrt hinaus ist nicht vorgesehen. Externe Dienste, die auf die frei verfügbaren OSM-Geodaten zurückgreifen (beispielsweise Routenplaner), können ihrerseits selbstverständlich Benutzerdaten speichern, ohne dass OpenStreetMap darauf Einfluss oder Zugriff hätte.

Der Kartendienst Apple Maps enthält neben den Navigationsdaten zum Beispiel auch Angaben über sogenannte Points of Interest, zum Beispiel dem Standort eines Restaurants. Im Gegensatz zum vorher in iOS (Betriebssystem für Mobilgeräte) enthaltenen Google-Maps-Dienst basiert Apple Maps weitestgehend auf Vektorgrafiken, die ein verlustfreies Zoomen ermöglichen. Dies ist darauf zurückzuführen, dass bei der Verwendung von Vektorgrafiken, beispielsweise alle Küstenlinien, Straßen, Straßenbezeichnungen durch mathematische Linien repräsentiert sind. Deshalb bleiben die Umrisslinien des Textes, beispielsweise von Straßenbezeichnungen erhalten, und es ändert sich nur der Schriftgrad, wenn der Benutzer hinein- oder herauszoomt. Dabei gibt es die Option, die App (Application software, Anwendungssoftware) entweder zugunsten einer besseren Sichtbarkeit auf die Bildschirmgröße des Mobilgeräts anzupassen (sogenanntes Upscaling) oder sie in einem kleinen Fenster anzuzeigen.

Viele von Internetnutzern durchgeführte Suchen beinhalten gewisse geografische Komponenten. Die Suche selbst kann geografische Informationen umfassen, z. B. eine Adresse, für die eine Karte und Wegbeschreibungen gesucht werden. Die Suche kann außerdem implizit geografische Ergebnisse erfordern, zum Beispiel, wenn die Suche den Namen eines Unternehmens mit einem bestimmten Ort umfasst. Solche Suchen können von einem Informationsdienstanbieter, wie Google Maps, empfangen und/oder die Ergebnisse können von einem solchen geliefert werden. Anwendungsprogrammierschnittstellen (Application Programming Interfaces, API) können es Fremdanbietern erlauben, die Funktionalität eines geografischen Informationsanbieterdienstes zu erweitern. Zum
Beispiel haben Programmierer Mithilfe einer API Daten aus Wohnungs- und Hausverzeichnissen genommen und Anwendungen erstellt, die diese Auflistungen auf einer Karte anzeigen, z. B. mit Google Maps. Basierend hierauf sind eine Reihe von Anmeldungen desselben Anmelders bekannt, welche sich mit Google Maps und Geodaten beschäftigen, insbesondere DE 20 2008 018 624 U1 (Karten-Gadgets), DE 20 2009 019 125 U1(Street-View), DE 20 2012 013 436 U1 (Zusatzinformationen auf Straßenadresse), DE 20 2014 010 911 U1 (Pixel- und Vektorgrafik), DE 20 2014 010 936 U1 (Pixel- und Vektorgrafik), DE 20 2015 009 166 U1 (individualisierte mobile Asset und geospatiale Asset), DE 20 2015 009 167 U1 (Geolokalisierung), DE 20 2015 009 187 U1 (POI+POS), DE 20 2015 009 325 U1 (mehrere geografische Bereiche und Zusatzinformationen), DE 20 2016 006006U1 (Zusatzinformationen für Reiseführer), DE 20 2016 006 041U1(Anzeige Standort und zusätzlicher Informationen), DE 20 2016 007 830U1 (interaktive digitale Kartenanwendung) und WO 2017-123439A1 (Panaroma-und Kartenansicht). Um eine Interaktion mit Karten wie denjenigen, die von Google Maps bereitgestellt werden, zu bieten, ist es aus der oben genannten DE 20 2008 018 624 U1 im Einzelnen bekannt, tragbare Programmmodule in Form von Gadgets in eine Kartenseite zu integrieren und die Entwicklung von Karten zu ermöglichen, die Daten aus mehreren verschiedenen Modulen anzeigen, was im Grunde ein Mashup der Mashups ermöglicht. Dabei kann die Kommunikation zwischen verschiedenen Modulen in iframes oder anderen Strukturen implementiert werden, bei denen jedes Modul normalerweise nicht dafür gedacht ist, frei mit anderen Modulen zu kommunizieren. Zum Beispiel können mehrere Gadgets mit einer Karte verbunden werden und sie können mit der Karte und miteinander kommunizieren. Weiterhin ist daraus ein computerimplementiertes Verfahren bekannt, welches die Anzeige von Informationen aus einer Kartenanwendung in einer ersten Domäne einer Webseite umfasst, wobei eines oder mehrere tragbare Programmmodule aus einer zweiten Domäne der Webseite angezeigt werden und eine Anzeige der Kartenanwendung auf Basis von Aktionen von einem oder mehreren tragbaren Programmmodulen erzeugt wird. Die tragbaren Programmmodule können in einem oder mehreren iframes erzeugt werden. Das Verfahren kann des Weiteren das Empfangen von Input an der Kartenanwendung und das Kommunizieren von Informationen hinsichtlich des Inputs an eines oder mehreren tragbare Programmmodule umfassen. Die Anzeige in der Kartenanwendung kann eines oder mehrere Objekte umfassen, die sich auf der Karte befinden. Weiterhin kann das Verfahren auch die Identifizierung von Kartendaten für die Anzeige auf der Webseite als Reaktion auf eine Suchanfrage umfassen. Das Verfahren kann außerdem die Identifizierung von einem oder mehreren tragbaren Programmmodule als Reaktion auf eine Suchanfrage umfassen. Außerdem kann das Verfahren die Identifizierung von einem oder mehreren tragbaren Programmmodulen durch Verweis auf ein Benutzerkonto umfassen, das personalisierte Seiten Informationen speichert. In noch einem weiteren Aspekt umfasst das Verfahren des Weiteren die Abfrage eines Datenservers für mit der Geografie verbundene Informationen und das Senden von Daten, die mit den mit der Geografie verbundenen Informationen verbunden sind, an einen Kartenserver, der vom Datenserver getrennt ist. Das Verfahren kann des Weiteren das Anzeigen von zwei kartenbezogenen tragbaren Programmmodulen umfassen, die mit unterschiedlichen Domains verbunden sind, und das Kommunizieren von Daten aus jedem der tragbaren Programmmodule an die Kartenanwendung. Für die dynamische Erzeugung von Karten, Werbung und anderen Elementen sind Anweisungen gespeichert, die bei Ausführung Aktionen auf einem Computer veranlassen. Die Aktionen umfassen die Anzeige von Informationen aus einer Kartenanwendung in einer ersten Domäne einer Webseite, wobei eines oder mehrere tragbare Programmmodule aus einer zweiten Domäne der Webseite angezeigt werden und eine Anzeige der Kartenanwendung auf Basis von Aktionen von einem oder mehreren tragbaren Programmmodulen erzeugt wird. Die Aktionen können des Weiteren das Empfangen von Input an der Kartenanwendung und das Kommunizieren von Informationen hinsichtlich des Inputs an eines oder mehrere tragbare Programmmodule umfassen. Außerdem können die Aktionen die Identifizierung von Kartendaten für die Anzeige auf einer Webseite als Reaktion auf eine Suchanfrage und die Identifizierung von einem oder mehreren tragbaren Programmmodulen als Reaktion auf eine Suchanfrage umfassen. Die Kommunikationsmodule sind so konfiguriert, dass sie mehrere Datenpakete verpacken, die zu oder von der Kartenanwendung in einem einzigen Paket gesendet werden. Außerdem kann das erste tragbare Programmmodul so konfiguriert sein, dass es mit einem Datenserver kommuniziert, um Geodaten zu erhalten, und mit einem Kartenserver oder einer Kartenanwendung, um Geodaten in mit der Geografie verbundene Daten umzuwandeln.

Weiterhin ist aus der DE 10 2007 016 978 A1 ein Verfahren zur Darstellung eines Wetterereignisses und ein Anzeigesystem hierfür bekannt. Die Darstellung einer Wetterlage oder von Wetterereignissen durch ein pixelbasiertes Bild hat den Nachteil, dass keine Ortsreferenzierung zu einer digitalen Straßenkarte vorhanden ist, damit keine Zuordnung zu einer Darstellung einer elektronischen Straßenkarte möglich ist, und daher eine separate Präsentation erfolgen muss. Auch bei Verwendung unterschiedlicher Vergrößerungsstufen muss entweder ein Bild nachgeladen werden oder man begnügt sich mit einer groben Pixeldarstellung oder bei bestimmten Ausschnitten dem Verlust von georeferenzierten Merkmalen zur Orientierung. Um den Fahrer eines Kraftfahrzeuges umfassend und leicht verständlich über ortsabhängige Wetterereignisse zu informieren wird basierend auf einer vektororientierten elektronischen Straßenkarte auf einer Anzeigeeinrichtung ein Teil einer Straßenkarte dargestellt. Es wird ein Wetterereignis-Objekt empfangen, das einen Wettercode, ein Flächenbeschreibungsobjekt und Referenzkoordinaten umfasst. Das Flächenbeschreibungsobjekt kann die Größe, die Ausrichtung und/oder die Form der Fläche beschreiben, indem beispielsweise Koordinaten weiterer Ecken oder Randpunkte einer geometrischen Form angegeben sind, oder indem Vektoren angegeben sind, die ausgehend von den Referenzkoordinaten eine geometrische Form oder einen Polygonzug beschreiben. Auf der Anzeigeeinrichtung wird dann basierend auf dem Wetterereignis-Objekt das Wetterereignis als der dargestellten Straßenkarte überlagerte Fläche, insbesondere transparent oder halbtransparent, dargestellt. Dadurch wird erreicht, dass gleichzeitig mit der Darstellung einer vektorbasierten Straßenkarte, insbesondere dieser überlagert, an der richtigen Stelle relativ zu dieser Straßenkarte ein Wetterereignis flächig dargestellt werden kann. Dadurch kann ein Fahrer schnell erfassbar und hinsichtlich der Lage zuverlässig über ein aktuelles oder prognostiziertes Wetterereignis informiert werden. Gegebenenfalls werden im Flächenbeschreibungsobjekt enthaltene Größeninformationen noch an den momentan eingestellten Zoomfaktor der Darstellung der Straßenkarte angepasst, um den Fahrer auch hinsichtlich der Größe zuverlässig über ein aktuelles oder prognostiziertes Wetterereignis zu informieren. Vorzugsweise basiert die vektororientierte elektronische Straßenkarte auf Knoten und Kanten oder ist dadurch beschrieben, wobei den Knoten jeweils die Koordinaten eines definierten Koordinatensystems zugeordnet sind. Dadurch, dass die Referenzkoordinaten ebenfalls durch Koordinaten des definierten Koordinatensystems beschrieben oder beschreibbar ist (gegebenenfalls nach einer entsprechenden Umrechnung), kann die flächige Wetterdarstellung einfach der richtigen Stelle oder dem richtigen Knoten der Straßenkarte zugeordnet werden und so bezogen auf die Straßenkarte an der richtigen Stelle dargestellt werden. Gemäß einer bevorzugten Ausführungsform wird die Lage der Fläche bezogen auf die Straßenkarte basierend auf zumindest einem Knoten der Straßenkarte und den Referenzkoordinaten bestimmt, beispielsweise indem die Referenzkoordinaten dem in dem Koordinatensystem nächstliegenden Knoten zugeordnet werden, oder indem die Lage der Referenzkoordinaten relativ zu zwei in der Nähe liegenden Knoten der Straßenkarte durch Interpolation oder Extrapolation bestimmt wird. Das Anzeigesystem weist auf : eine Anzeigeeinrichtung zur Darstellung zumindest eines Teils einer Straßenkarte basierend auf einer vektororientierten elektronischen Straßenkarte, eine Empfangseinrichtung zum Empfangen eines Wetterereignis-Objektes, das einen Wettercode, ein Flächenbeschreibungsobjekt und Referenzkoordinaten umfasst, und eine Prozessoreinrichtung, die derart eingerichtet ist, dass basierend auf dem Wetterereignis-Objekt das Wetterereignis als der dargestellten Straßenkarte überlagerte Fläche auf der Anzeigeeinrichtung dargestellt wird.

Um eine erste Benutzervorrichtung sowie ein System mit der ersten Benutzervorrichtung zu schaffen, die beziehungsweise das eine zuverlässige und/oder aktuelle Bereitstellung einer Navigationsinformation durch die erste Benutzervorrichtung ermöglich, ist es aus der DE 10 2012 202 356 A1 bekannt, dass die erste Benutzervorrichtung eine digitale erste Karteninformation aufweist und derart ausgebildet ist, dass an der ersten Kommunikationsschnittstelle eine Anforderungsnachricht zur Bereitstellung einer Navigationsinformation bezüglich zumindest eines gewünschten Routenabschnitts ausgegeben wird. Die zweite Kommunikationsschnittstelle empfängt eine Navigationsinformation, die in Antwort auf die Anforderungsnachricht an der zweiten Kommunikationsschnittstelle bereitgestellt wird und die eine digitale zweite Karteninformation für zumindest einen Teil des gewünschten Routenabschnitts umfasst. Die digitale zweite Karteninformation enthält Daten zur Darstellung des zumindest einen Teils des gewünschten Routenabschnitts. Die erste Benutzervorrichtung ermittelt eine digitale aktualisierte Karteninformation und steuert abhängig von der digitalen zweiten Karteninformation der Navigationsinformation und der digitalen ersten Karteninformation eine optische Ausgabevorrichtung zum Darstellen der digitalen aktualisierten Karteninformation an. Wenn die erste digitale Karteninformation den zumindest einen Routenabschnitt nicht umfasst oder fehlerhaft umfasst, beispielsweise weil ein bestimmter geografischer Bereich nicht digitalisiert ist, nicht aktualisiert ist und/oder nicht ausreichend genau beschrieben ist, kann die Navigations-Information für diesen Routenabschnitt angefordert werden, beispielsweise von einer zentralen Einrichtung. Die angeforderte Navigationsinformation kann dann von der zentralen Einrichtung indirekt, über eine zweite Benutzervorrichtung, der ersten Benutzervorrichtung zur Verfügung gestellt werden. Die erste und zweite Kommunikationsschnittstelle der ersten Benutzervorrichtung sind jeweils vorzugsweise als bidirektionale Schnittstellen ausgebildet. Die Navigationsinformationen kann zur Vervollständigung einer Routenanzeige der ersten Benutzervorrichtung genutzt werden. Auf diese Weise kann zum einen die für einen Nutzer der ersten Benutzervorrichtung erkennbare Routenanzeige zuverlässig und/oder aktuell bereitgestellt werden. Ferner kann auf diese Weise beispielsweise auch eine Navigationsfunktion in komplexen Zielgebieten, zum Beispiel in Einkaufsparks und Flughäfen, zuverlässig bereitgestellt werden, die häufig nicht von der in der ersten Benutzervorrichtung gespeicherten ersten digitalen Karteninformation umfasst sind. Zusätzlich kann die Funktionalität der zweiten Benutzervorrichtung genutzt werden, um die Navigationsinformation anzupassen, zum Beispiel an eine aktuelle Position der ersten Benutzervorrichtung und/oder eines Fahrzeugs. Die erste Benutzervorrichtung kann in dem Fahrzeug fest angeordnet sein. Ferner kann die Funktionalität der zweiten Benutzervorrichtung genutzt werden, um die Navigations-Information mit weiteren Informationen zu ergänzen. Die Navigationsinformation kann beispielsweise mit Grafikelementen und/oder Textinformationselementen und/oder Inhaltsinformationselementen für vorgegebene in der ersten Benutzervorrichtung vorhandene Anzeige- und/oder Bedienvisualisierungselement ergänzt werden. Die indirekte Bereitstellung der angeforderten Navigationsinformation für die erste Benutzervorrichtung hat den Vorteil, dass die zusätzliche Funktionalität der zweiten Benutzervorrichtung genutzt werden kann und somit die zusätzliche Funktionalität, auch nach einer Installation der ersten Benutzervorrichtung, bereitgestellt werden kann. Es ist besonders vorteilhaft, dass die in der ersten Benutzervorrichtung vorhandene erste digitale Karteninformation genutzt werden kann und die zweite digitale Karteninformation der Navigationsinformation in diese eingebettet werden kann, so dass die digitale aktualisierte Karten Information sehr einfach ermittelt werden kann. Dies ermöglicht jeweils nur kleine Datenmengen übertragen zu müssen, insbesondere von der zentralen Einrichtung zur zweiten Benutzervorrichtung. Die digitale aktualisierte Karteninformation kann in der ersten Benutzervorrichtung derart ermittelt werden, dass auf der optischen Ausgabevorrichtung die zweite digitale Karteninformation der Navigationsinformation der ersten digitalen Karteninformation überlagert dargestellt wird. Dieses Einbetten mittels einer Bildschirmüberlagerung, auch als Groundoverlay oder Mapoverlay bezeichnet, ermöglicht eine flexible und einfache optische Darstellung der ersten und zweiten Karteninformation. In einer weiteren Ausgestaltung umfasst die digitale zweite Karteninformationen Daten zur Darstellung von geplanten Fahrtrouten und/oder von Fahrmanöverhinweisen entlang des gewünschten Routenabschnitts und/oder der aktuellen Position der ersten Benutzervorrichtung relativ zu dem gewünschten Routenabschnitt und/oder von Verkehrshinweisen. Vorteilhafterweise ermöglicht dies, diese weiteren Informationen einfach bereitzustellen und mittels der optischen Ausgabevorrichtung anzuzeigen. Weiterhin kann die Navigationsinformation eine Kartenausschnittsinformation und ein oder mehrere Grafikelemente umfassen. Ferner ist die erste Benutzervorrichtung ausgebildet, das beziehungsweise die zur Verfügung gestellten Grafikelemente in die digitale aktualisierte Karteninformation zur Darstellung des durch die Kartenausschnittsinformation vorgegebenen Kartenausschnitts einzubetten und die optische Ausgabevorrichtung in Antwort auf die Kartenausschnittsinformation zum Darstellen des vorgegebenen Kartenausschnitts anzusteuern. Dies ermöglicht eine einfache, flexible Darstellung der Grafikelemente. Diese kann beispielsweise eine zusätzliche Darstellung von aktuellen Positions-Informationen in der Kartendarstellung auf der optischen Ausgabe Vorrichtung ermöglichen, ohne dass jeweils die zweite digitale Karteninformation aktualisiert werden muss. Es ist besonders vorteilhaft, dass die in der ersten Benutzervorrichtung vorhandene digitale aktualisierte Karteninformation genutzt werden kann und lediglich die zusätzlichen Grafikelemente eingebettet werden. Weiterhin zeichnet sich das System dadurch aus, dass eine erste Benutzervorrichtung eine Zentralrechnervorrichtung und eine zweite Benutzervorrichtung aufweist. Die Zentralrechnervorrichtung weist eine Kommunikationsschnittstelle auf, die ausgebildet ist, die an der ersten Kommunikationsschnittstelle der ersten Benutzervorrichtung bereitgestellte Anforderungsnachricht zu empfangen und zur Verfügung zu stellen. Die Zentralrechnervorrichtung ist ausgebildet, in Antwort auf die empfangene Anforderungsnachricht eine zentrale Navigationsinformation an der Kommunikationsschnittstelle zur Übertragung an die zweite Benutzervorrichtung bereitzustellen. Die zentrale Navigationsinformation umfasst die digitale zweite Karteninformation für den zumindest einen Teil des zumindest einen Routenabschnitts. Die zweite Benutzervorrichtung umfasst eine dritte Kommunikationsschnittstelle und eine vierte Kommunikationsschnittstelle. Die dritte Kommunikationsschnittstelle ist ausgebildet, die empfangene zentrale Navigationsinformation der zweiten Benutzervorrichtung zur Verfügung zu stellen. Die zweite Benutzervorrichtung ist ausgebildet, die Navigationsinformation an der vierten Kommunikationsschnittstelle zur Übertragung an die erste Benutzervorrichtung bereitzustellen, wobei die Navigationsinformation die digitale zweite Karteninformation für den zumindest einen Teil des zumindest einen Routenabschnitts umfasst. Dies ermöglicht eine zuverlässige und/oder aktuelle und/oder einfache Bereitstellung der angeforderten Navigationsinformation. Ferner ermöglicht dies, unterstützt durch Funktionalität der zweiten Benutzervorrichtung, eine Darstellung der Navigationsinformation in einer Weise, dass die Navigationsinformation für einen Betrachter der optischen Ausgabevorrichtung einfach wahrnehmbar ist. Die zweite Benutzervorrichtung ist insbesondere als mobiles Endgerät ausgebildet und kann beispielsweise ein Smartphone sein. Die zweite Benutzervorrichtung kann eine Laufzeitumgebung umfassen, beispielsweise ein mobiles Betriebssystem oder einen Browser. Die dritte und vierte Schnittstelle der zweiten Benutzervornchtung sind jeweils vorzugsweise als bidirektionale Schnittstelle ausgebildet. Die zweite Benutzervorrichtung kann beispielsweise einfach mit einer geeigneten Rechenleistung ausgestattet sein, die erforderlich ist für gegebenenfalls im Vorfeld des Zur-Verfügung-Stellens der Navigationsinformation erforderlichen Rechenoperationen. Darüber hinaus kann sie beispielsweise einfach hinsichtlich ihrer Software aktualisiert werden und ist so sehr leicht anpassbar. Die Grafikelemente können grundsätzlich beliebige Grafikelemente sein. Sie können beispielsweise auch Symbole für eine Geschwindigkeitsüberwachung sein oder beispielsweise auch Wetterinformationen symbolisieren und beispielsweise ein vorgegebenes Farbmuster für die Stärke eines Niederschlags aufweisen, wie dies beispielsweise bei einem so genannten Regenradar der Fall ist. So können die Grafikelemente jeweils einen vorgegebenen Geobezug aufweisen und ihnen somit bestimmten Geodaten zugeordnet sein, wie beispielsweise bei einer Radarfalle, welcher an einer vorgegebenen Position an einer Straße angeordnet ist. Darüber hinaus kann grundsätzlich dem jeweiligen Grafikelement, das an der zweiten Kommunikationsschnittstelle empfangen wird, auch eine Bildschirm Positionsinformation zugeordnet sein, mit der Folge, dass es an einer entsprechend vorgegebenen Position bezogen auf den Bildschirm dargestellt wird unabhängig von dem aktuellen Maßstab des dargestellten Kartenausschnitts. Dies wird auch als Screenoverlay bezeichnet. Dies ist beispielsweise für die Darstellung von Eingabeauswahlmitteln vorteilhaft, wie dies beispielsweise im Falle eines Fadenkreuzes der Fall sein kann. Darüber hinaus können in der zweiten Benutzervorrichtung auch ein oder mehrere Textinformationselemente ermittelt werden, die an der vierten Kommunikationsschnittstelle der zweiten Benutzervorrichtung für die erste Benutzervorrichtung zur Verfügung gestellt werden. So kann beispielsweise zu einem Grafikelement ein diesem zugeordnetes Textelement bereitgestellt werden, das beispielsweise eine nähere Beschreibung des jeweiligen Grafikelements umfasst. So zum Beispiel wann eine entsprechende Radarfalle entdeckt wurde oder, im Falle eines Ziels von Interesse (Point of Interest), weitere beschreibende Textinformationen. Es ist somit auch möglich, mittels der zweiten Benutzervorrichtung Widgets in der ersten Benutzervorrichtung anzusteuern. In diesem Zusammenhang werden insbesondere so genannte Karten-Widgets gesteuert. Diese umfassen Anzeigen der Karte, beliebiges Positionieren und/oder Zoomen der Karte und zwar im Hinblick auf den darzustellenden Kartenausschnitt, das Einzeichnen von Routen, insbesondere in Form von einer Polylinie mit Geokoordinaten und/oder Einzeichnen von Icons. Darüber hinaus können auf diese Weise auch Points of Interest (Ziele von Interesse) übergeben werden und entsprechend referenziert v/erden. Darüber hinaus kann so einfach das grafische Darstellen von Bildschirm Überlagerungen und/oder 3D-Modellen und/oder Ortsmarken erfolgen Ferner kann auch so ein Zooming oder so genanntes Panning erfolgen. Die Navigationsinformation kann beispielsweise auch Sprachdaten und/oder Haptikdaten umfassen, die von der ersten Benutzervorrichtung genutzt werden können zum Ansteuern einer akustischen beziehungsweise einer haptischen Ausgabevorrichtung. Auf dies Weise ist es beispielsweise insbesondere möglich, Fahrmanöverhinweise bezüglich des gewünschten Routenabschnitts akustisch auszugeben.

Weiterhin ist es aus der DE 10 2013 201 873 B4 ein Verfahren zur dynamischen Ausgabe von Informationen auf einem portablen Gerät bekannt, um Personen aus einem Gebäude zu evakuieren. Das Verfahren umfasst das Bestimmen der aktuellen Positionsdaten des Gerätes durch ein Positionsbestimmungssystem, das Bestimmen der aktuellen Verwendbarkeit von im Gebäude befindlichen Fluchtwegen durch eine geeignete erste Sensorik, das Ermitteln von Evakuierungsinformationen durch eine Steuereinheit, basierend auf der aktuellen Verwendbarkeit der Fluchtwege und der aktuellen Position des Gerätes; und das Ausgeben der Evakuierungsinformation auf dem portablen Gerät. Fluchtwege sind je nach der Anzahl der Personen in den verschiedenen Gebäudeteilen stark oder weniger stark ausgelastet. Weiterhin können Fluchtwege durch Hindernisse (z. B. durch Brand oder Rauch) versperrt oder nur schwer passierbar sein. Die Räumung eines Gebäudes erfolgt allerdings schneller, wenn die Personen dynamisch (je nach Auslastung bzw. Verfügbarkeit) zu offenen und passierbaren Fluchtwegen geführt werden. Die aktuelle Verwendbarkeit von Fluchtwegen kann z. B. durch sowieso schon im Gebäude befindliche Kameras überwacht und bestimmt werden. Mit Vorteil wird die Evakuierungsinformation auf portablen Geräten ausgegeben, die sich sowieso schon im Besitz von Benutzern (wie zum Beispiel Smartphones, portable Media Player (PMP), d. h. tragbare Medienabspielgeräte oder aber auch Tablet-PC) befinden. Prinzipiell kann die Evakuierungsinformation aber auch auf portablen Geräten ausgegeben werden, die ein Benutzer (Besucher) erst im Gebäude ausgehändigt bekommt (z. B. ein elektronischer Museumsführer oder ein sogenannter Multimedia-Guide). Mit Vorteil ist das portable Gerät mit einem Positionsbestimmungssystem (z. B. GPS-System) ausgestattet ist, welches zur Positionsbestimmung des Gerätes verwendbar ist. Es ist aber auch möglich, dass das Bestimmen der aktuellen Positionsdaten des Gerätes durch ein separates Positionsbestimmungssystem, z. B. ein im Gebäude befindliches "Indoor-Positionsbestimmungssystem (Indoor Positioning System, IPS) erfolgt. Im Prinzip kann ein IPS auch auf freiem Gelände installiert sein. Ein IPS kann z. B. durch entsprechend angeordnete lokale Funkzellen realisiert sein, wie WLAN-Knoten, Hotspots, Accesspoints etc. Weiterhin ist die Bereitstellung von dedizierten Evakuierungsinformationen entsprechend der aktuellen Lokalisation und Situation für die jeweiligen Personen möglich. Eine erste vorteilhafte Ausgestaltung liegt dann, dass die Bestimmung der aktuellen Verwendbarkeit von Fluchtwegen auf deren jeweiligen Auslastung und/oder deren Passierbarkeit beruht. Fluchtwege sind je nach der Anzahl der Personen in den verschiedenen Gebäudeteilen stark oder weniger stark ausgelastet. Weiterhin können Fluchtwege durch Hindernisse (z. B. durch Brand oder Rauch) versperrt oder nur schwer passierbar sein. In den Fluchtwegen (z. B. Treppenhäusern) werden geeignete Sensoren (z. B. Kameras und/oder Rauch-/Gasmelder) platziert. Diese Sensoren erfassen z. B. Rauch, Anzahl der Personen (Auslastung). Dadurch kann die Auslastung bzw. Verwendbarkeit (Fluchtweg verraucht) eines Fluchtweges ermittelt werden. Die Räumung eines Gebäudes erfolgt allerdings schneller, wenn die Personen dynamisch (je nach Auslastung bzw. Verfügbarkeit) zu offenen und passierbaren Fluchtwegen geführt werden. Die aktuelle Position des Gerätes ist auch ein Hinweis auf die aktuelle Position des Geräteinhabers. Dadurch können für eine Person jeweils dedizierte Evakuierungsinformation (d. h. in Abhängigkeit vom Aufenthaltsort und der vorliegenden Gefahren Situation) auf dem portablen Gerät ausgegeben werden. Eine weitere vorteilhafte Ausgestaltung liegt darin, dass ein Gebäudeplan des Gebäudes auf das Gerät geladen wird und die Evakuierungsinformation als Routinginformation auf dem Gebäudeplan grafisch auf dem Gerat ausgegeben wird. Der Gebäudeplan kann z. B. aus einem Gebäudeinformationsmodell (Building Information Model, BIM) generiert und auf das portable Gerät geladen werden, z. B. über eine WLAN-Verbindung beim Betreten eines Gebäudes. Handelt es sich beim portablen (mobilen) Gerät um ein Gerät, welches einer Person beim Betreten eines Gebäudes ausgehändigt wird (z. B. Multimedia-Guide in einem Museum), dann ist mit Vorteil dieses Gerät bereits mit dem entsprechenden Gebäudeplan bestückt. Das mobile Gerät kann die Fluchtweg-Daten (Evakuierungsdaten) ähnlich wie bei handelsüblichen Navigationssystemen in einer 2D/3D-Grafik (Map) darstellen. Es ist aber auch möglich die Evakuierungsdaten z. B. im Kamera-Live-View-Modus (bzw. Live-Preview-Modus), wie es bei Digitalkameras bekannt ist, darzustellen. Die Darstellung der Evakuierungsinformation auf dem Gebäudeplan kann z. B. durch Informationseinblendung (Bild und/oder Textinformation) mittels Overlaytechnik erfolgen (z. B. durch direktes Hardware-Overlay oder auch durch Software-Overlay). Eine weitere vorteilhafte Ausgestaltung liegt darin, dass der Gebäudeplan des Gebäudes auf das Gerät über das Internet oder durch das Einlesen einer am Gebäude befindlichen Kennzeichnung durch eine geeignete Lesevorrichtung des Gerätes geladen wird. Der Gebäudeplan kann über das Internet durch einen Service-Provider auf das mobile Gerät geladen werden. Der Benutzer meldet sich bei dem Service-Provider an, der als Inhaltsanbieter fungiert und u. a. die Gebäudepläne bereitstellen kann. Das Herunterladen eines Gebäude- oder Geländeplans kann z. B. auf Aufforderung (on demand) durch einen Benutzer erfolgen. Es ist aber auch möglich, dass das Herunterladen des Gebäude- oder Geländeplans durch einen Push-Dienst (durch eine Push-Technologie) erfolgt. Der Benutzer meldet sich dazu bei einem Internet-Service-Provider an. Zur Evakuierung von Personen, insbesondere aus Gebäuden, umfasst ein portables Gerät einer jeweiligen Person, eine Anordnung mit einer geeigneten ersten Sensorik zur Bestimmung der aktuellen Verwendbarkeit der jeweiligen im Gebäude befindlichen Fluchtwege, einem Positionsbestimmungs-System zur Bestimmung der Positionen von im Gebäude befindlichen Personen, einer Steuereinheit zur Echtzeitverarbeitung der von der ersten Sensorik und der vom Positionsbestimmungssystem gelieferten Daten; wobei von der Steuereinheit basierend auf der aktuellen Verwendbarkeit der Fluchtwege und der aktuellen Position einer bestimmten Person Evakuierungsinformation auf dem portablen Gerät dieser Person bereitgestellt wird. Diese Anordnung lässt sich leicht realisieren oder in einem bestehenden Gebäude bzw. Gelände nachrüsten, da diese üblicherweise schon im Gebäude bzw. bei einem Benutzer vorhanden sind. Als geeignete erste Sensorik zur Bestimmung der aktuellen Verwendbarkeit der jeweiligen im Gebäude befindlichen Fluchtwege können z. B. Kameras verwendet werden, die sich schon im Gebäude befinden oder leicht an den entsprechenden Orten (z. B. in Treppenhäusern oder hinter Notausgangstüren) nachrüstbar sind. Als Positionsbestimmungssystem kann z. B. ein GPS-System des portablen Gerätes (Smartphones sind heutzutage bereits mit GPS-System ausgestattet bzw. kann ein GPS-System über eine App auf einem Smartphone nachgerüstet werden). Es ist aber auch möglich ein Indoor-Positionsbestimmungssystem zu verwenden (z. B. basierend auf im Gebäude befindlichen Funkzellen, basierend auf RFID-Technologie oder durch Near Field Communication (NFC)). Die Steuereinheit (z. B. ein handelsüblicher Computer, wie Server, PC oder Laptop) zur Echtzeitverarbeitung der von der ersten Sensorik und der vom Positionsbestimmungssystem gelieferten Daten ist mit entsprechender Software (Kommunikationssoftware zur Kommunikation mit dem portablen Gerät, Simulationssoftware oder Entscheidungstabellen zur Bereitstellung der Evakuierungsinformation basierend auf der aktuellen Situation im Gebäude, etc.) ausgestattet. Die Evakuierungsinformation wird auf Ausgabemedien (Display. Lautsprecher des portablen Gerätes optisch (grafisch und/oder textlich) und/oder akustisch (z. B. in Form von Handlungsanweisungen) ausgegeben. Eine weitere vorteilhafte Ausgestaltung liegt darin, dass die Anordnung Teil eines Gebäudeleit- und/oder Gefahrenmeldesystems ist. In einem Gebäudeleit- oder Gefahrenmeldesystem sind statische (Pläne) und dynamische Daten (z. B. Zimmerbelegungen in einem Hotel) vorhanden bzw. zentral abgreifbar. Durch die Integration in ein Gebäudeleit- oder Gefahrenmeldesystem können im Gefahrenfall (z. B. Brand) geeignete Rettungsmaßnahmen auf einzelne Personen zielgerichtet koordiniert bzw. veranlasst werden.

Weiterhin ist es aus der DE 10 2011 015 216 A1 ein Endgerät zur Visualisierung von Adresspunkten auf dargestellten digitalen Karten und ein entsprechendes Verfahren zum Betrieb des Endgerätes bekannt. Um eine Visualisierung von beliebig vielen individuellen Adresspunkten auf einer digitalen Karte zu ermöglichen, wobei die Visualisierung unabhängig vom Anbieter der digitalen Karten ist, umfasst das Endgerät ein Anzeigemittel zur Darstellung der digitalen geographischen Karten und zur Visualisierung der Adresspunkte, einen Datenspeicher, in dem ein oder mehrere Adresspunkte mit jeweils zugeordneten Geokoordinaten und jeweils ein oder mehrere zugeordnete Zusatzinformationen gespeichert sind, ein Datenkommunikationsmittel geeignet zur Aussendung einer geeigneten Kartenanfrage an einen Kartendatenanbieter und zur Übertragung zumindest einer von dem Kartendatenanbieter übertragenen ersten digitalen geographische Karte auf den Datenspeicher des Endgeräts, wobei die übertragene digitale Karte ein Gebiet umfasst, in dem eine durch das Endgerät vorgegebene Referenzkoordinate enthalten ist, einen Prozessor, der zur Bestimmung der Entfernung der Adresspunkte zu der Referenzkoordinate aus den im Datenspeicher gespeicherten Geokoordinaten der Adresspunkte und der Referenzkoordinate und der zur Auswahl der Adresspunkte, die innerhalb eines vorgegebenen Gebiets um die Referenzkoordinate liegen, ausgestaltet ist, und ein Verknüpfungsmittel, das die ausgewählten Adresspunkte mit mindestens einer der zugeordneten Zusatzinformationen als Symbole verknüpft und diese Symbole zur Visualisierung der Adresspunkte auf zumindest der ersten geographischen Karte an den jeweils den Adresspunkten zugeordneten Geokoordinaten darstellt. Zur Darstellung einer digitalen geographischen Karte im Anzeigemittel muss eine solche Karte erst in das Endgerät geladen werden. Für die Bereitstellung des Kartenmaterials zur Übertragung einer digitalen geographischen Karte auf das Endgerät kann beispielsweise der sogenannte Bing-REST-Service von Microsoft genutzt werden. Für die Nutzung dieses Services ist eine Datenverbindung zu dem Service notwendig. Diese Datenverbindung wird über das Datenkommunikationsmittel des Endgeräts hergestellt, das beispielsweise ein Mobilfunkmodul oder eine Schnittstelle zum Anschluss an ein Datennetz, beispielsweise das Internet, ist. Um eine digitale geographische Karte von einem Kartendatenanbieter zu erhalten, muss eine entsprechende Kartenanfrage an diesen Anbieter ausgesendet werden. In einer Ausführungsform umfasst die von Endgerät ausgesendete Kartenanfrage zumindest die Größe eines Kartenausschnitts und Geokoordinaten oder eine Adresse, die die Referenzkoordinate bezeichnet. Des Weiteren kann diese Kartenanfrage einen gewünschten Zoomfaktor und/oder zur Identifikation des Endgeräts eine Kennung der Anfrage und einen Authentifizierungsschlüssel umfassen. Damit die Adresspunkte in dem vorgegebenen Gebiet um die Referenzkoordinate visualisiert werden können, muss der Ort, der durch die Referenzkoordinaten bestimmt ist, innerhalb der angefragten geographischen Karte liegen. Damit das sichergestellt ist, kann die Referenzkoordinate durch eine Geokoordinate in der Kartenanfrage bezeichnet werden. Die von Kartendatenanbieter übertragene digitale geographische Karte hat bei einer solchen Kartenanfrage in der Regel das Formal einer Grafikdatei, die entweder vektorbasiert oder pixelbasiert sind. Alternativ kann die Kartenanfrage zur Bezeichnung der Referenzkoordinate auf die der Referenzkoordinate entsprechende Adresse umfassen. In dieser Ausführungsform werden zusätzlich zu der übermittelten digitalen geographischen Karte die XML-Metadaten des Kartenausschnitts in den Datenspeicher geladen. So kann auch bei dieser Gestaltung der Kartenanfrage für die Auswahl der zu visualisierende Adresspunkte eine Berechnung auf Basis von Geokoordinaten durchgeführt werden. Der Begriff "geographische Karte" umfasst hierbei alle Arten von Karten, mit denen eine Position auf der Karte bestimmbar ist. Solche geographischen Karten können beispielsweise Straßenkarten, Stadtpläne, Luftbilder der Erdoberfläche oder andere entsprechende Karten sein. Der Begriff "Referenzkoordinate" bezeichnet dabei die Geokoordinaten eines Ortes, in dessen Umgebung die Adresspunkte visualisiert werden sollen. Die Referenzkoordinate kann beispielsweise der momentane Ort des Endgerätes sein. Damit dieser Ort mit dem Endgerät bestimmbar ist, kann das Endgerät ein Modul zur Messung seiner Position, beispielsweise anhand eines der vorhandenen Satellitennavigationssysteme, sein. In einer Ausführungsform umfasst das Endgerät ein GPS-Modul zur Bestimmung der Position des Endgeräts. Die Referenzkoordinaten können alternativ dazu auch mittels Cursor auf einer im Anzeigemittel dargestellten Karte gewählt werden. Hier kann beispielsweise im Voraus geplant werden, welche Kunden in einem bestimmten Umkreis um eine Adresse noch zusätzlich aufgesucht werden könnten. Die dargestellten Symbole könne jede geeignete Form und Farbe besitzen. Insbesondere kann die Größe, Form und Farbe der Symbole der jeweiligen Anwendung angepasst werden. Beispielsweise können die Symbole als B oder als Kreis mit einem B im Falle von Bedarfskunden an diesem Adresspunkt oder als P oder als Kreis mit einem P im Falle von potentiellen Kunden ausgeführt sein. In einer Ausführungsform ist das Anzeigemittel so ausgestaltet, dass die Symbole anklickbar sind, wobei das Verknüpfungsmittel so ausgestaltet ist, die Symbole mit weiterer Zusatzinformation zu hinterlegen, die nach dem Anklicken in einem zusätzlichen Fenster im Anzeigemittel angezeigt wird. Dadurch bleibt die Visualisierung der Adresspunkte durch die Symbole auf der dargestellten digitalen geographischen Karte auch bei einer größeren Anzahl an Symbolen übersichtlich und eventuell notwendige Zusatzinformation zu der einzelnen Adresspunkten ist im Bedarfsfall schnell über das Anzeigemittel anrufbar und einsehbar. Der Vorteil ist hier das Anzeigen eines einzelnen Fensters für ein angeklicktes Symbol. Wären stattdessen alle Fenster zu allen Symbolen gleichzeitig geöffnet, wäre möglicherweise die geographische Karte nicht mehr erkennbar und könnte so auch nicht mehr zur Orientierung verwendet werden. Das Anklicken kann in bekannter Weise beispielsweise durch einen Cursor oder im Falle eines berührungsempfindlichen Anzeigemittels durch Antippen des Symbols mit einem Finger oder einem Stift vorgenommen werden. In einer weiteren Ausführungsform sind die Symbole für verschiedene Adresspunkte mit gleichen Geokoordinaten als gemeinsamer Multipin zugeordnet zu einer Mehrzahl an Adresspunkten ausgebildet. Beispielsweise können zwei unterschiedliche Adresspunkte zwei unterschiedliche Kunden in demselben Gebäude (beispielsweise in unterschiedlichen Stockwerken) bezeichnen. Somit besitzen diese unterschiedlichen Adresspunkte die gleiche Adresse bzw. die gleichen Geokoordinaten, die üblicherweise durch die Adresse bzw. durch das betreffende Gebäude bestimmt sind. Die Adresspunkte sollten hier aus Gründen der Übersichtlichkeit und der Bedienbarkeit nicht als separate Symbole, die sich gegenseitig zumindest teilweise überlagern, dargestellt werden. Der Multipin kann zur Unterscheidung von den übrigen Symbolen, die jeweils nur einen einzelnen Adresspunkt bezeichnen, mit einer anderen Farbe (beispielsweise rot bei sonst grünen Symbolen), mit einer anderen Form (beispielsweise größer als die übrigen Symbole oder eckig anstatt sonst rund) oder als anderes Symbole (beispielsweise als "M" für Multipin anstatt "S" für Symbol). In einer weiteren Ausführungsform ist das Anzeigemittel und/oder das Verknüpfungsmittel so ausgestaltet, dass durch Anklicken des Multipins eine Auflistung der dem Multipin zugeordneten Adresspunkte in dem zusätzlichen Fenster angezeigt wird, vorzugsweise umfasst die Auflistung ein oder mehrere Zusatzinformationen zu den jeweiligen Adresspunkten. Auf diese Weise kann analog zu den Symbolen für einen einzelnen Adresspunkt auch hier in übersichtlicher Weise die Zusatzinformationen zu den jeweiligen Adresspunkten des Multipins angerufen und eingesehen werden. In einer weiteren Ausführungsform ist das Anzeigemittel so ausgestaltet, dass ein oder mehrere Bedienersymbole neben und/oder auf der dargestellten geographischen Karte dargestellt werden, deren Betätigung zu einer geänderten Darstellung der geographischen Karte und/oder zu einer geänderten Visualisierung der Adresspunkte führt. Als die Bedienersymbole können beispielsweise die Zoomstufen der geographischen Karte verändert werden (kleinere/größerer Kartenausschnitt) oder ein Hauptmenü des Endgerätes aufgerufen werden, um zu anderen Funktionalitäten des Endgeräts zu gelangen. Dies wären bei einem Mobilfunkgerät als Endgerät beispielsweise alle üblichen Funktionen des Mobilfunkgeräts wie ein Bedienerfenster zum Abschicken einer SMS oder zum Anwählen eines anderen Mobilfunkteilnehmers, ein Fenster zum Eingeben von Daten aller Art etc. Andere Bedienersymbole könnten beispielsweise ein Kompass-Icon zur Eingabe einer neuen Referenzkoordinaten via GPS oder ein Steuerungssymbol zum Verschiebender geographischen Karte in X- und/oder Y-Richtung sein. In Abhängigkeit von der jeweiligen Anwendung können weitere Bedienersymbole hinzugefügt, geändert oder weggelassen werden. In einer Ausführungsform ist das Anzeigemittel zur Anzeige eines Filtermittels ausgestaltet, mit dem anhand einer Auswahl bestimmter Zusatzinformationen die Visualisierung lediglich einer Teilmenge der ursprünglich dargestellten Adresspunkte vorgenommen werden kann. Ein Filtermittel ist beispielsweise ein sogenanntes Scroll-down-Menü, indem beispielsweise alle Arten von vorhandenen Zusatzinformationen, wie Kundennummer, Geokoordinaten, Kundenart, Vertriebsart, Multipin-Ja/Nein, und gegebenenfalls weitere Zusatzinformationen aufgelistet sind und in dem eine bestimmte Art an Zusatzinformationen ausgewählt werden kann, beispielsweise über Anklicken der gewünschten Art der Zusatzinformation. Als Folge der Auswahl mit dem Filtermittel werden nur die Adresspunkte in dem Anzeigemittel über Symbole visualisiert, die in diese Kategorie der Art der Zusatzinformation fallen. Beispielsweise werden nur die Adresspunkte über die Symbole visualisiert, die einer bestimmten Kundenart, beispielsweise potentielle Kunden, zugeordnet sind.

Weiterhin ist aus einer Veröffentlichung von Jens PÖNISCH "OpenStreetMap-Karten selbst gebaut." TU Chemnitz, 2012, [online abrufbar] URL: http://nbn-resolving.de/urn:nbn:de:bsz:ch1-qucosa-86465, eine Nachbauanleitung für OpenStreetMap-Karten unter Benutzung von Kacheln und frei verfügbaren Geodaten, Werkzeugen zum Erstellen von Karten und deren Rendern, einschließlich Erzeugung von Icons und Beschriftungen (insbesondere POI Point of Interest), anschaulich beschrieben und erläutert.

Die Darstellung eines POI Attributes ist aus der US 2015/0 067 598 A1 bekannt. Im Einzelnen umfasst das dort beschriebene System zum dynamischen Visualisieren von POI-Attributinformationen (Point of Interest) eine POI-Attributdatenbankeinheit, welche die POIs und Attributinformationen der POIs speichert. Weiterhin ist eine POI-Bedingungssucheinheit vorgesehen, die zum Durchsuchen der POI-Attributdatenbankeinheit nach Attributinformationen von POIs in Abhängigkeit von mehreren Bedingungen zum Erzeugen der gesuchten POIs konfiguriert ist. Ferner umfasst das System eine Dienstbereitstellungseinheit, die konfiguriert ist, um Dienste - wie etwa einen Webkartendienst oder einen Navigationsdienst unter Verwendung der gesuchten POIs - auszuführen, die von einer POI-Zustandssucheinheit in Bezug auf geographische Informationsobjekte anhand von Geodaten bereitgestellt werden. Die POI-Zustandssucheinheit durchsucht die POI-Attributdatenbankeinheit nach Attributinformationen von POIs (z.B. verfügbare Stunden des POI, verfügbarer Benutzertyp usw.), die in Diensten in Abhängigkeit von mehreren Bedingungen verwendet werden, und liefert die gesuchten POIs an die Dienstbereitstellungseinheit. Weiterhin ist eine Anzeigeeinheit vorgesehen, welche zum Anzeigen von Ergebnissen des Dienstes konfiguriert ist. Die Funktionen der POI-Bedingungssucheinheit und der Dienstbereitstellungseinheit werden zentral von einem Server verwaltet. Gemäß einer Ausführungsform des in der US 2015/0 067 598 A1 beschriebenen Systems/Verfahrens zum dynamischen Festlegen und Verwalten von POI-Attributinformationen ist es möglich, unterschiedliche Attributinformationen des POI festzulegen, einen POI darzustellen und bereitzustellen, der bestimmte Bedingungen erfüllt, basierend auf den festgelegten Attributinformationen, oder die unterschiedlichen Attributinformationen zusammen mit dem POI in einer Vielzahl bereitzustellen und zu visualisieren. Dies führt zu einer effizienten Bereitstellung und Visualisierung des POI bei gleichzeitiger Minimierung der Benutzereingaben.

Durch das deutschlandweite Projekt der Bundesregierung "Industrialisierung 4.0" und "Digitalisierung 4.0" entstehen neue Herausforderungen um die zum Teil sehr umfangreiche Datenmengen auch auf möglichst allen Userendgeräten unabhängig vom Betriebssystem nutzen zu können. Besonders im Bereich von Vektorgraphiken besteht ein Bedarf an der Verknüpfung von grafischen Zeichnungsinformationen mit Zusatzinformationen, die durch den Enduser in Echtzeit beeinflussbar sein sollen.

Die Nutzerdaten können in unterschiedlicher Form vorhanden sein:
A. Als Vektordaten aus Maschinenbauzeichnungen, Chemieanlagen, Leiterplattenlayouts, Stromlaufpläne, Zusammenbauzeichnungen, Architektenentwürfe, Baupläne, Lageplänen, Liegenschaftsdaten, Havariezeichnungen, Gebäude- oder Raumplänen von Architekten
B. Als Pixelbilder in unterschiedlichen Formaten Schwarz/Weiß- Strichzeichnungen, eingescannte Bauzeichnungen, farbige Fotos, Luftbildaufnahmen oder Havariepläne mit Zusatzinformationen wie z.B. Sammelplätze, Notausgänge, Bestuhlungspläne, Feuerlöscher, Gefahrgüter, ...
C. Alphanumerische Informationen von GPS-Koordinaten, Zutrittsberechtigungen, Telefonnummern, Schlüsselinhaber, Notdienste, Energieversorger, Absperrschieber, Sicherungskästen, Katastrophenschutz, Landesämtern, Aufbewahrungsplätze für Havariedokumente oder zu Bereichsverantwortlichen.

Diese Nutzerdaten sollen auf einfache Weise vektorisiert zusammengeführt und auf möglichst vielen mobilen Ausgabemedien für eine breite Nutzung im Web verfügbar gemacht werden.

Nutzer mit Vektorgrafik/CAD-Daten haben, wenn sie diese Daten in einer Cloud ablegen nur die Möglichkeit, in einem Servicefall den gesamten CAD-File auf einen PC zu laden und mit einem geeigneten CAD-System zur Anzeige zu bringen. Cloud Computing beschreibt die Bereitstellung von IT-Infrastruktur wie beispielsweise Speicherplatz, Rechenleistung oder Anwendungssoftware als Dienstleistung über das Internet, d.h. den Ansatz, IT-Infrastrukturen über ein Rechnernetz zur Verfügung zu stellen, ohne dass diese auf dem lokalen Rechner installiert sein müssen. Public Cloud bietet Zugang zu abstrahierten IT-Infrastrukturen für die breite Öffentlichkeit über das Internet, wobei Kunden, IT-Infrastruktur auf einer flexiblen Basis des Bezahlens für den tatsächlichen Nutzungsgrad bzw. Verbrauch (pay-as-you-go) mieten können, ohne Kapital in Rechner- und Datenzentrumsinfrastruktur investieren zu müssen. Das Angebot und die Nutzung dieser Dienstleistungen erfolgen mittels eines Webbrowsers und eines Public-Cloud-Diensteanbieter. Eine Private Cloud ist eine Cloud-Umgebung, welche ausschließlich für eine Organisation betrieben wird. Das Hosten und Verwalten der Cloud-Plattform kann intern (beispielsweise durch firmeneigene Rechenzentren) aber auch durch Dritte erfolgen. Eine Hybrid Cloud bietet kombinierten Zugang zu abstrahierten IT-Infrastrukturen aus den Bereichen von Public Clouds und Private Clouds, je nach den Bedürfnissen ihrer Nutzer. Im Zusammenspiel mit dem CAD-System benötigt jeder Nutzer, beispielsweise jeder Servicetechniker, Architekten, Bauleiter, Havariedienst,... einen Schulungsaufwand und die Nutzung verursacht hohe Lizenzkosten.

Wie die vorstehende Würdigung des Standes der Technik aufzeigt, ist die Sammlung von Geodaten und darauf basierenden Kartendiensten seit mehr als einem Jahrzehnt bekannt. Bei Google-Earth werden Vektorgrafikdaten auch vor der Anzeige auf den Bildschirmen in Pixeldaten umgewandelt, aber es ist nicht möglich beispielsweise eigene Raumpläne mit Bestuhlung, Ausschnitte von Katasterkarten, Havariepläne mit Geländebesonderheiten oder Gefahrenstoffen selbst und ohne kostspielige Software mit Zusatzinformationen zu versehen und an diese Zusatzinformationen noch Rückgabewerte im Web eingeben zu können.

Aus der CN 107 402 928 A sind Übertragung von CAD-Dateien von einem Server auf einen Client und Anzeige dieser auf dem Client bekannt.

Der Erfindung liegt die Aufgabe zugrunde, ein Verfahren und eine Vorrichtung zur Übertragung und Anzeige von nutzereigenen Vektorgraphiken mit intelligenten Infopunkten aus einem cloudbasierten CAD-Archiv derart auszugestalten, dass unter Beachtung von Zugriffsrechten neben einer CAD-Datei zusätzliche Informationen möglichst in Echtzeit auf unterschiedlichen Plattformen dargestellt werden können.

Diese Aufgabe wird bei einem Verfahren zur Übertragung und Anzeige von Vektorgraphiken mit Zusatzinformationen aus einem cloudbasierten CAD-Archiv auf Mobilgeräten, tragbaren oder stationären Computern, gemäß Patentanspruch 1, gelöst.

Weiterhin wird diese Aufgabe durch eine Vorrichtung zur Übertragung und Anzeige von Vektorgraphiken mit Zusatzinformationen aus einem cloudbasierten CAD-Archiv auf Mobilgeräten, tragbaren oder stationären Computern, nach Patentanspruch 15 gelöst.

Das erfindungsgemäße Verfahren und die erfindungsgemäße Vorrichtung weisen den Vorteil auf, dass auf überraschend einfache Art und Weise im Internet beispielsweise für Anbieter von Dienstleistungen, Objektverwaltern, Kommunen, Sportvereinen, Rettungsdiensten, Feuerwehr, Umweltämter, Katastrophenschutz, ... eine Plattform geschaffen werden kann, auf der graphische Vektor- und Pixelgraphik- Daten mit Zusatzinformationen bei der Web-Anzeige verknüpft, in unterschiedlichen Farben angezeigt sowie mit Zusatzinformationen versehen werden können. Damit können, obwohl die Übertragung der kompletten Vektordaten nicht echtzeitfähig ist, unter Beachtung von Zugriffsrechten beispielsweise sehr große Zeichnungen zusammen mit Zusatzinformationen in einem Ausschnittsbereich detailgetreu/mit hoher Auflösung auf Mobilgeräten, tragbaren oder stationären Computern o.ä. schnell und zusammen mit einer aktuellen Information angezeigt werden. Die graphischen Daten können CAD- Maschinenbauzeichnungen, Chemieanlagen, Leiterplattenlayouts, Stromlaufpläne, Zusammenbauzeichnungen, Architektenentwürfe, Baupläne, Liegenschaftskarten, Luftbildaufnahmen, Geländeausschnitte, Ferienhäuser, Raumpläne von Messen, Theater, Besprechungsräume oder Konferenzsälen,... sein.

Weitere Vorteile und Einzelheiten lassen sich der nachfolgenden Beschreibung von bevorzugten Ausführungsformen der Erfindung unter Bezugnahme auf die Zeichnungen entnehmen. In der Zeichnung zeigt:
Fig. 1a schematisch die Aufbereitung und Anzeige von Vektor- und Pixelbildern mit Zusatzinformation im WEB für den Nutzerbereich und Bereich des Endusers,
   - Fig. 1b: für den zentralen Rechnerbereich und
   - Fig. 1c: die gesamte Vorrichtung mit den Ausgestaltungen nach Fig. 1a und Fig. 1b zur Realisierung des erfindungsgemäßen Verfahrens,
   - Fig. 2: den Ablaufplan des erfindungsgemäßen Verfahren für die in Fig. 1c dargestellte Vorrichtung,
   - Fig. 3: ein Beispiel für ein Mutterbild als Pixelgrafik,
   - Fig. 4: ein Beispiel für einen Ausschnitt aus der Mutterskizze nach Fig. 3 als Vektorgrafik und
   - Fig. 5: derselbe Ausschnitt als Pixelgrafik aus dem Mutterbild.

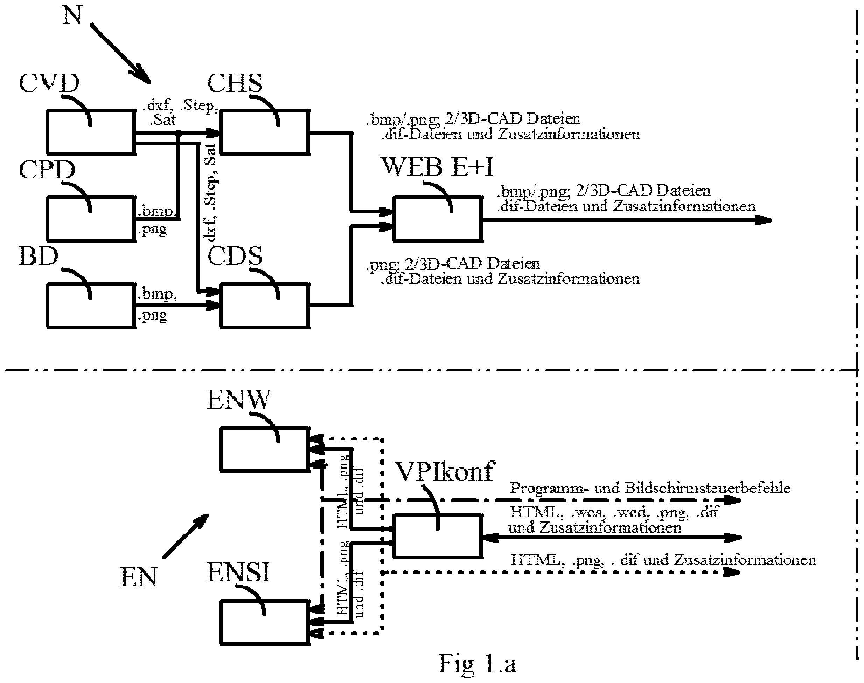

Fig. 1a bis Fig. 5 zeigen die Realisierung des erfindungsgemäßen Verfahrens für ein cloudbasiertes CAD-Archiv (CA) zur Anzeige von nutzereigenen Vektorgraphiken mit zur Laufzeit änderbaren intelligenten Infopunkten auf beliebigen mobilen und stationären Frontend's (EN), insbesondere Mobilgeräten, tragbaren oder stationären Computern im Web.

Im ersten Schritt kann die Pixelgrafik durch die Verknüpfung mit intelligenten Zusatzinformationen über HTML- Anzeigen über einen zentralen Web-Server (ZR) aus einer Nutzer-Cloud bereitgestellt werden. Dies hat den Vorteil, dass fast alle Endgeräte (EN) die bereitgestellten HTML-Informationen mit ausschließlich systemeigenen Komponenten (Internet-Explorern) arbeiten können. Weiterhin kann eine leistungsfähige zentrale Hardware mit hoher Bearbeitungsgeschwindigkeit und Robustheit der einzelnen Applikationen auf dem Server (ZR) genutzt werden. Allerdings hat diese Variante zum Einen den Nachteil einer verhältnismäßig großen Pixelgrafikdatei und damit längeren Übertragungszeit im Netz vor allem in Nichtballungsgebieten und zweitens müssen die Endgeräte-Applikationen immer durch den Enduser auf dem aktuellen Stand gehalten werden.

Wenn dem Web-User aber die Datei im zweiten Projektschritt als Vektorgrafik- Daten mit intelligenten Zusatzinformationen übertragen wird, dann ist die Datenmenge im Vergleich zur Pixelgrafik meist nur eine extrem kleine Datei, die oft nur weniger als ein Hundertstel an Übertragungskapazität im Netz benötigt. Der Nachteil ist, dass die Vektorgrafikdaten erst auf dem User-Endgerät (EN) für die Bildschirmanzeige aufbereitet werden muss. Da es keine einheitliche Vektordaten- Schnittstelle für PC's, Smartphones oder Iphones außer der HTML-Standardanzeige gibt und Zusatzinformationen oder die Rückgabe von Daten an das zentrale Serversystem für einzelne Applikationen angepasst werden müssen, ist immer eine Individual-Programmierung nötig.

Bei Google-Earth werden Vektorgrafikdaten auch vor der Anzeige auf den Bildschirmen in Pixeldaten umgewandelt, aber es ist nicht möglich eigene Raumpläne mit Bestuhlung, Ausschnitte von Katasterkarten, Havariepläne mit Geländebesonderheiten oder Gefahrenstoffen selbst ohne kostspielige Software mit Zusatzinformationen zu versehen und an diese Zusatzinformationen noch Rückgabewerte im Web eingeben zu können. Es können diese Rückgabewerte z.B. einfache Stuhlreservierungen, oder ob sich die Feuerwehr und der Technische Hilfsdienst an einem Sammelplatz befindet, im Web zum zentralen Server gesendet werden. In Sekundenschnelle sehen nachfolgende User ob ein Platz bereits verkauft, reserviert oder frei ist. Eine Havariezentrale kann graphisch durch unterschiedlich farbliche Markierung der Zusatzinformationen sehen, ob an kritischen Stellen Einsatzkräfte auch weitentfernt voneinander vor Ort (an 20km - Flusslauf, Slipstellen für Boote, Sammelräume für Fahrzeuge) sind. Bei komplexen Chemieanlagen können Absperrschieber, Fluchtwege, Feuerlöschgeräte, Alarmtaster und Rettungshilfsmittel auf verschiedenen Ebenen/Etagen bildhaft dargestellt werden.

Beim erfindungsgemäßen Verfahren werden die Daten in einem geeigneten CAD-Format in einer Cloud abgelegt und zur Nutzungszeit in ein im Standard-Web anzeigbaren Pixelgrafikformat (CPG) auf dem Server oder auf dem Frontend (EN) (Tablet, Smartphone, Iphon, PC,...) gewandelt. Dadurch kann dann fast jedes mobile Endgerät (EN) diese Daten anzeigen oder ausdrucken. Wenn es sich um sehr große Zeichnungen handelt, dann kann in der Pixelgrafik ein Ausschnittsbereich aus einer Mutterskizze (Gesamtzeichnung) an den Server gesendet werden. Der Server wandelt den entsprechenden Vektorgrafik-Ausschnitt (CVG) aus der CAD-Zeichnung wieder in eine detailgenauere Pixelgrafik (CPG) und überträgt diesen Ausschnitt an die mobilen Frontends (EN). Bei sogenannten Powerusern (EN) werden vom Server die entsprechenden Zeichnungs-Ausschnitts-Vektoren an die Enduserapplikation übertragen und die Umwandlung des Vektorgrafik-Zeichnungsausschnitts wird auf dem Frontend (EN) in eine Pixelgrafik (CPD) umgewandelt.

Beim erfindungsgemäßen Verfahren wird beispielsweise von einem Servicetechniker kein CAD-System auf seinem Frontend (EN) benötigt. Es eignen sich sogar Smartphone oder iPhone für die Anzeige oder das Ausdrucken der CAD-Zeichnungen, auf denen kein CAD-System verfügbar ist.

Des Weiteren kann auch durch den Nutzer (N), in die CAD- oder Pixelgrafik-Zeichnung (CVG/CPG) durch Zufügen von intelligenten Infopunkten (CInf) mit der Möglichkeit zur Laufzeit Zusatzinformationen an die Infopunkte zu übertragen, ein weiterer Nutzen entstehen.

Die Infopunkte übertragen diese Zusatzinformationen beim nächsten Abruf vom Server an die weiteren Enduser (EN).

Infopunkte können durch Farbänderungen, Reservierungen oder Textinformationen ihre Anzeigestati ändern. Somit kann dieselbe Technologie auch für beliebige Reservierungen z.B. von Ferienwohnungen, Sportstätten, Räumen, Hotelzimmer, Tischen in Besprechungsräumen oder Restaurants sowie für Platzreservierungen in Kinos, Bussen, Flugzeugen oder Eisenbahnen genutzt werden.

Infopunkte können im Katastrophenfall in geografischen CAD-Zeichnungen in Liegenschaftskarten oder Gebäudegrundrissen von Havariediensten, Katastrophenschutz, Feuerwehr, Polizei, Wasserrettung, Grenzschutz, Militär oder Behörden in Echtzeit zur Informationsübertragung bereichsübergreifend genutzt werden, z.B. zur Markierung von Flut- oder Rettungswegen, Hydranten, Sammelplätzen...

Infopunkte könne zur Laufzeit auf den Frontends (EN) zum besseren Auffinden in der Größe autonom verändert werden, ohne den Server kontaktieren zu müssen.

Wie vorstehend beschrieben betrifft die Erfindung die Bereitstellung eines Cloud-Archiv's (CA) für 2D/3D- CAD-Daten (CVD) mit Infopunkten für die Nutzung durch mobile und stationäre Frontends (EN) (Iphones, Smartphones, Notebooks, Tablett- /Desktop-PC's oder Workstations) mit unterschiedlichen Betriebssystemen im Internet. Die nutzereigenen CAD-Daten (CVD) können als CAD- Austauschformate wie z.B. im 2D-CAD das dxf-Format oder im 3D-CAD die Step- oder Sat-Formate für das Cloud-Archiv (CA) bereitgestellt werden. Die einzelnen CAD-Dateien (CVD) werden vor der Aufbereitung für das Cloud-Archiv (CA) auf Viren-, Konsistenz und Fehlerfreiheit geprüft und gegebenenfalls für jeweils eine CAD-Datei (CVD) mit nutzereigenen Infopunkten (CInf) und einer Versionsnummer versehen.

Nach erfolgreicher Prüfung wird zu jeder einzelnen nutzereigenen CAD-Datei (CVD) (auch Mutterskizze genannt) als Gesamtheit eine komprimierte Pixelgrafikdatei [Bilddatei (.png, .gif, .tif, ...)] erstellt und gemeinsam mit einer oder mehreren Infopunkte-Dateien (CInf) verschlüsselt in dem Cloud-Archiv (CA) eingespeichert.

Der Nutzer (N) bekommt ein Passwort für seinen Nutzerzugriff unter Berücksichtigung des Datenschutzes auf einem zweiten Weg mitgeteilt. Er kann für seine Endusergruppen eigene Passwörter und Zugriffsrechte für die einzelnen CAD-Daten (CVD) oder Infopunkt-Informationen (CInf) in seinem Cloudbereich festlegen.

Abgerufene Daten aus dem Cloud-Archiv (CA) werden verschlüsselt und komprimiert zum Enduser (EN) übertragen. Die Eigenschaften für die Infopunkte, wie z.B. Farbe, Größe, sichtbar/unsichtbar, und Zusatzinformationen werden erst durch eine App auf den Frontends enduserabhängig angezeigt.

Die Dateinamen für Mutterskizzen setzen sich getrennt durch Unterstrich [ _ ] aus der
a) Nutzeridentifikation [z.B. E24T789DLGHZER47 (für bessere Lesbarkeit mit Leerzeichen versehen E24 T78 9DL GHZ ER47)]
b) Datum der ersten Einspeicherung [D20170523 (23. Mai.2017)]
c) Uhrzeit [T1437 (14:37 Uhr)]
d) Kennung für 2D oder 3D [2D]
e) Version [V001] und der
f) CAD- System- oder Austauschformat-Kennung (Suffix - .wca, .dxf, .step, .sat, ...)
g) zusammen.

Der vollständige Dateiname für die obige Mutterskizze aus einem üblicherweise benutzten 2D CAD- System WorldCAT-dxfEdit lautet:
**E24T789DLGHZER47_D20170523_T1437_2D_V001.wca**

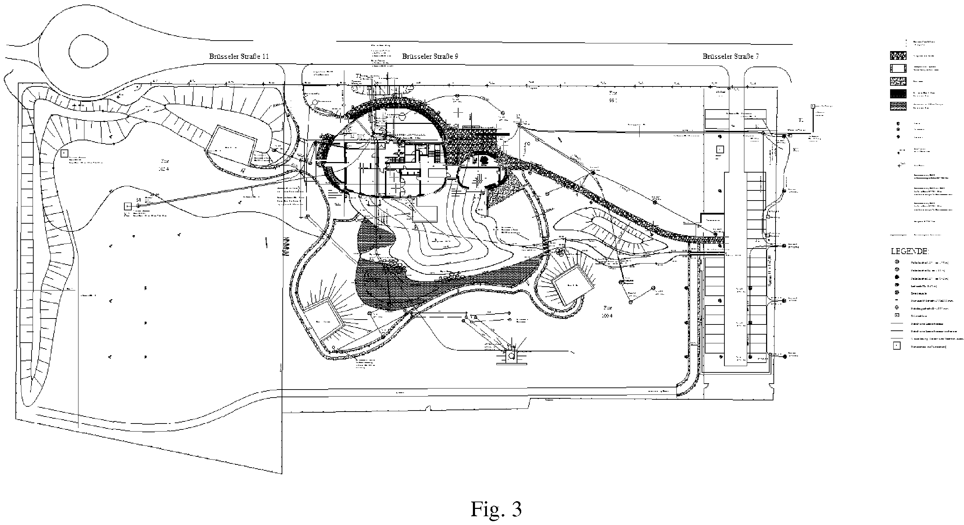

Daraus abgeleitet würde sich für eine komprimierte Bilddatei einer Mutterskizze, wie diese beispielsweise in Fig. 3 dargestellt ist, als Gesamtheit im 4K Bildschirm -Pixelformat 3840x2160 ergeben:
**E24T789DLGHZER47_D20170523_T1437_2D_V001_P3840_2160_XA0001_XE3800_YA0 001_YE2160.png**

Die Erweiterungen ergeben sich aus der Bildgröße des Gesamtbildes aus der Mutterskizze
- Bildgröße des Gesamtbildes [P3840_2160 (Horizontal 3800 Pixel; Vertikal 2160 Pixel)]
- Bildauschnitt [XA0001_XE3840_YA0001_YE2160
   (Horizontal: Anfangspunkt 0001 Endpunkt 3840 und
   Vertikal: Anfangspunkt 0001 Endpunkt 2160]
- Datei-Suffix [.png].

Für einen Infopunkt lautet z.B. die Dateibezeichnung:
**E24T789DLGHZER47_D20170523_T1437_2D_V001_ITNR001_.dif** mit der Erweiterung:
- Dateiartkennung Text gefolgt von einer fortlaufenden Nummer [ITNR001 oder IDNR001].
- Datei-Suffix [.dif].

Ein einfachstes Beispiel könnte eine **Ferienanlage** mit mehreren Ferienhäusern sein. Der Anbieter/Nutzer (N) übergibt einen CAD- Lageplan (CVD) mit den Ferienhäusern als dxf- File und den Hausnummern an das System. Es wird eine Pixelgrafik (CPD) auf Wunsch mit noch einigen Anpassungen (z.B. Parkplätze am Haus) erstellt und die zugehörigen Hausnummern erhalten farbige Infopunkte (CInf). Jetzt kann der Anbieter/Nutzer N seinen Lageplan im Internet mit seiner Homepage verbinden und es wird aktuell "Grün" angezeigt, ob im Moment ein Ferienhaus frei, "Gelb" reserviert oder "Rot" belegt ist. Zusätzlich kann durch Klicken auf den Infopunkt (CInf) eine alphanumerische Belegungsliste angezeigt werden. Ein Enduser (EN) kann auf Wunsch einen freien Termin am Infopunkt "Gelb" reservieren lassen und der Anbieter kann nach Vertragsbestätigung auf "Rot" belegt setzen. Es ist für Kleinstanbieter/Nutzer (N) keine kostspielige Reservierungssoftware nötig, da die Aufbereitung einfach ist, oder als Dienstleistung von einem ortsansässigen Dienstleister erfolgen kann. Weiterhin kann eine Termintabelle mit Adressverweis des Interessenten (Enduser EN) pro Infopunkt abgerufen werden.

Ein anspruchsvolleres Herangehen wäre bei einem Geländeplan eines Rettungsdienstes an einem mehrere Kilometer langem Abschnitt eines Fließgewässers möglich. Es wird eine CAD- Karte (CVD) des Katastrophenschutzes oder Liegenschaftsdienstes des Gewässers mit Infopunkten (Clnf) (Slipstellen von Rettungsbooten, Sammelräume, Schließberechtigte für Schranken auf Deichanlagen, Pegelstandsanzeigen oder Rückwärtige Parkplätze für Rettungsfahrzeuge außerhalb des Gefahrenbereichs versehen.

Bei einer Anzeige von Pixelgrafiken über eine Länge des Fließgewässers von mehr als 20km, würden die Infopunkte in der Gesamtansicht nicht mehr sichtbar sein. Durch eine variable Größe der farbigen Infopunkte in dem Geländeplan .. kann in der Gesamtansicht z.B. die Lage der vorhandenen Slip-Stellen gut sichtbar sein. Eine Slipstelle wird ausgewählt und eine sehr starke Ausschnittsvergrößerung mit Detailinformationen vom Web-Server abgerufen. Nun kann die Information "Rettungsteam ist an der Slipstelle" in Echtzeit an den Infopunkt z B. über Smartphone gegeben werden und der Infopunkt nimmt eine andere Farbe an. An einem Sammelpunkt kann die Information "Es befinden sich 63 Menschen an der Sammelstelle" an den Infopunkt (CInf) gegeben werden. Der Sammelstelleninfopunkt (CInf) nimmt eine andere Farbe an und gibt die Information 63 Menschen über die Karteninformation an andere Hilfsdienste oder eine Leitzentrale weiter.

Als sogenannter PowerUser EN mit einem mobilen Endgerät (z.B. Smartphone) kann die Datenmenge bei der Übertragung von Vektordaten an Stelle von Pixelgrafikdaten extrem verringert werden, so dass in Nichtballungsgebieten oder in Bereichen schwachen Telefonsignalen ein großer Kartenausschnitt mit sehr vielen Detail- Informationen trotzdem übertragen und angezeigt werden kann. Die Umwandlung der einzelnen Vektoren des gewünschten Ausschnitts aus der Gesamtzeichnung und die Verbindung mit den intelligenten Infopunkten (CInf) erfolgt in diesen Fall auf dem mobilen Endgerät eines Endusers (EN).

Beim erfindungsgemäßen Verfahren werden Infopunkte mit ihren Eigenschaften durch geeignete Erweiterungen des grafischen Grundelementes (Punkt) von 2D oder 3D CAD- Systemen lagegenau in der CAD- Datei (Mutterskizze) gespeichert, als Infopunkt (CInf) kenntlich gemacht und durch Zusatzdateien für die Anzeige im Cloud-Archiv für das Internet durch den Nutzer (N) oder seinen CAD-Dienstleister aufbereitet. Durch ein automatisches Auslesen der Infopunkte (CInf) und der Verbindung mit seinen Zusatzinformationen wird eine Infopunkt- Datei mit allen Anzeige und Zusatzinformationen zur Mutterskizze erzeugt.

Da Infopunkte in einer eigenständigen Infopunkt- Datei (CInf) neben der Vektorgrafik-Mutterskizze (CVD) und der Gesamtbild- Pixelgraphikdatei (CPD) (im Einzelnen siehe Fig. 1a bis Fig. 1c) abgelegt werden, sind für den jeweiligen Infopunkt alle Informationen für die Anzeige im Vektor- oder Pixelgraphikformat gleichermaßen verwendbar.

Die Übergabe der Infopunkt-Informationen (CInf) für einen normalen Enduser (EN) kann mit vereinfachten Mitteln der Frontends als Pixelgraphik und für einen sogenannten Poweruser als Vektorgraphik erfolgen. Die normalen Enduser (EN) können die Ausschnittsvergrößerung immer nur vom Cloud-Archiv (CA) abrufen und die Eigenschaften wie Infopunktgröße, - Zugriffsberechtigungen oder -Farbe für eine vereinfachte und übersichtliche Suche der Infopunkte in der Bilddatei durch eine App auf dem Frontend nutzen. Ausschnittsvergrößerung und die Zuordnung der Infopunkte (CInf) in dem Ausschnittsfenster erfolgen beim erfindungsgemäßen Verfahren auf der Serverseite der Cloud.

Poweruser (EN) können aus dem Cloud- Archiv (CA) neben den Möglichkeiten des normalen Endusers (EN) die Infopunkt-Informationen (CInf) auch auf den Frontends mit den Vektorgrafik-Daten durch eine erweiterte Applikation mit der Mutterskizze verbinden.

Dazu werden die originalen Vektordaten (CVD) der Mutterskizze oder ein Ausschnitt mit allen in ihm enthaltenen Vektoren aus dem Cloud-Archiv (CA) auf das Frontend-Gerät geladen, durch eine App in eine Pixelgraphik CPG umgewandelt und dann erst mit den Infopunkt-Informationen CInf verbunden.

Diese Technologie hat den Vorteil, dass diese Information auch dann verfügbar ist, wenn es keine ausreichende Qualität der Internetverbindung oder in abgelegenen Gebieten sowie in Kellerräumen gar keine Netzverbindung besteht. Die Konvertierung der Vektorgrafik und die Verknüpfung mit den Infopunktinformationen erfolgt dann ausschließlich durch die App auf dem Frontend-Gerät.

Infopunkte können, wenn der Nutzer (N) diese Möglichkeit den Endusern (EN) gestattet auch lagegenau auf den Frontends erzeugt und in eine temporäre Infopunktdatei (CInf) in dem Cloud-Archiv (CA) gespeichert werden. Der Nutzer (N) kann die Übernahme der externen Infopunktinformationen veranlassen oder selbst durchführen und die Mutterskizze unter einer neuen Versionsnummer in dem Cloud-Archiv (CA) ablegen. Für einen nachfolgenden Enduser (EN) wird immer die letzte Versionsnummer der Mutterskizze zur Anwendung gebracht.

Mit Infopunkten können Zusatzinformationen wie Reservierungen für Objekte, Adressen, Stati, Alarmierungen, Technische Informationen, Schwellenwerte, Anzeigeoptionen (Infopunktgröße/Farbe/Triggerpunkte) oder Verweise auf andere Dateien beliebiger Art verbunden werden.

Offene Schnittstellen und SDK's (Software Development Kids) sollen Fremdnutzern die Nutzung der Anzeigetechnologie mit den intelligenten Infopunkten auf beliebigen Frontends (EN) gestatten eigene Applikationen zu schaffen. Infopunkte und die Zusatzinformationen der Enduser (EN) können für die Steuerung eigener Prozesse, Reservierungen, Adressübermittlungen, Aktualisierung von CAD- Zeichnungen, Handbüchern, und beliebigen weiteren Nutzungen eingesetzt werden.

3D- CAD -Poweruser (EN) können die Infopunkte aus ihren 3D- CAD- Dateien (z.B..Step oder .Sat) in den üblichen sechs Ansichten (Vorn, Hinten, Oben, Unten und Seite Links/Rechts) aus der Mutterskizze in eine Pixelbilddatei (CPD) umgewandelt und anzeigen. Die Infopunkte werden dann für die Frontends (EN), insbesondere Mobilgeräten, tragbaren oder stationären Computern in die entsprechende Anzeigeansicht projiziert und weiter wie in 2D als Pixelgraphik angezeigt und genutzt.

Durch eine Erweiterungs-App der Frontends (EN) für die freie Drehung im 3D mit Rendering und Tracing kann durch die Anzeige und das Bewegen von 3D- Objekten im dreidimensionalen Raum die Anzeige und Orientierung vereinfacht, sowie das Auffinden von Infopunkten erleichtert werden. Nach einer Auswahl und der Markierung eines Infopunktes im dreidimensionalen Raum sowie der Umwandlung der Anzeigeansicht der gesamten Mutterskizze oder eines Ausschnitts in ein Pixelgraphikbild mit der lagerichtigen Anzeige des Infopunktes, können alle weiteren Aktivitäten auch wie im 2D im vollen Umfang genutzt werden

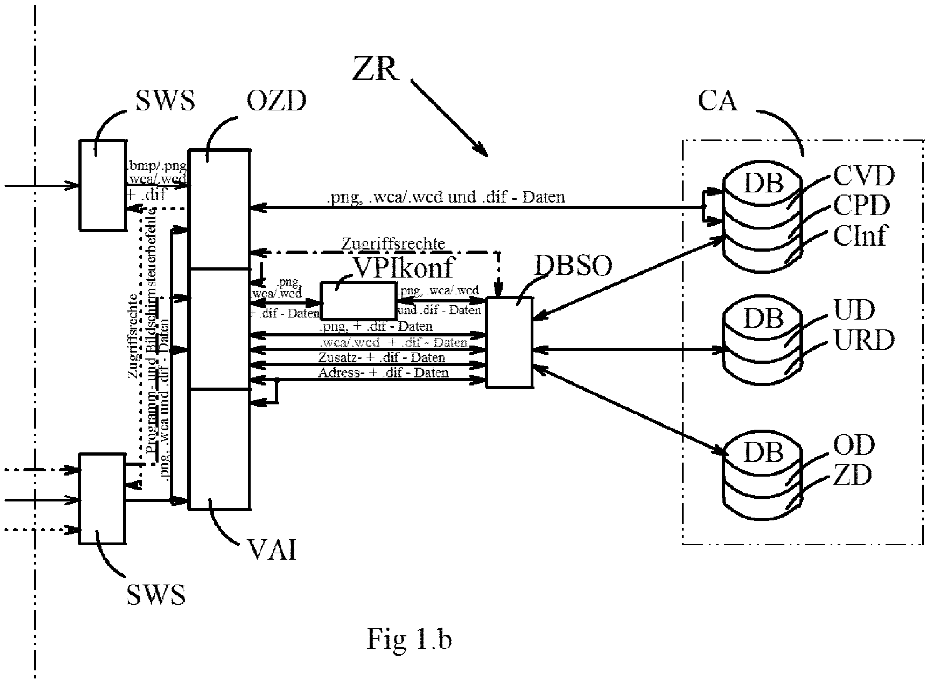

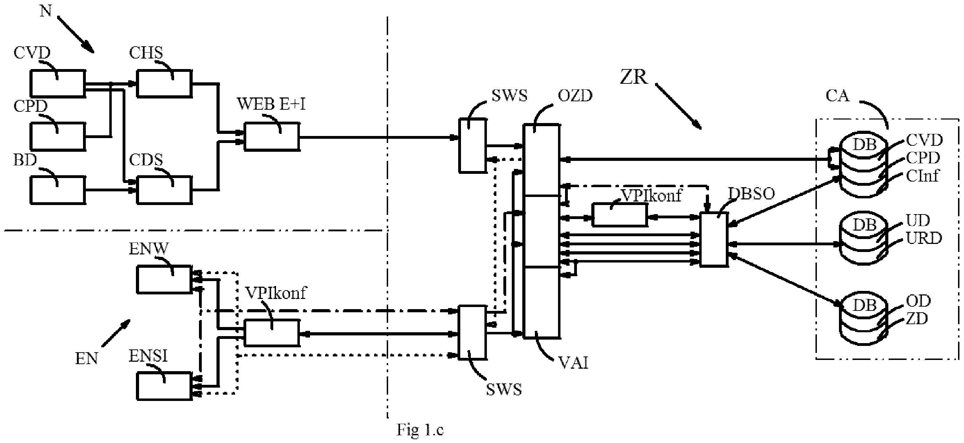

Fig. 1a zeigt schematisch die Aufbereitung und Anzeige von Vektor- und Pixelbildern mit Zusatzinformation im WEB für den Nutzerbereich (N) und Bereich des Endusers (EN), Fig. 1b für den zentralen Rechnerbereich (ZR) und Fig. 1c die gesamte Vorrichtung mit den Ausgestaltungen nach Fig. 1a und Fig. 1b zur Realisierung des erfindungsgemäßen Verfahrens. Im Einzelnen weist der Nutzerbereich (N) ein CAD- Hybrid System (Vektor/Pixel) (CHS) auf, welchem nutzereigene Pixelbilddateien (CPD) (Endung .bmp oder .png) und nutzereigene CAD-Datei (CVD) (Endung .dxf oder .Step oder .Sat) zugeführt werden. Weiterhin weist der Nutzerbereich (N) ein CAD- Digitalisier System (CDS) auf, welchem nutzereigene Pixelbilddateien (CPD) (Endung .bmp oder .png) und nutzereigene CAD-Datei (CVD) (Endung .dxf oder .Step oder .Sat) zugeführt werden. Schließlich weist der Nutzerbereich (N) eine weitere nutzereigene Pixelbilddateien (BD) (Endung .bmp oder .png) auf, welche mit dem CAD- Digitalisier System (CDS) verbunden ist. CAD- Hybrid System (Vektor/Pixel) (CHS) und CAD- Digitalisier System (CDS) sind im Nutzerbereich (N) mit einem Modul Web-Daten Export und Import (WEB E+I) verbunden, welchem die .bmg/.png- und 2/3 D-CAD-Daten und . dif-Daten und Zusatzinformationen des CAD- Hybrid Systems (Vektor/Pixel) (CHS) und die .png- und 2/3 D-CAD-Daten und . dif-Daten und Zusatzinformationen des CAD- Digitalisier Systems (CDS) zugeführt werden. Die am Ausgang des Moduls Web-Daten Export und Import (WEB E+I) anstehenden .bmg/.png- und 2/3 D-CAD- Daten und . dif-Daten und Zusatzinformationen werden einem im zentralen Rechnerbereich angeordneten Modul Sicherheitslayer Web-Server (SWS) zugeführt.

Weiterhin zeigt Fig. 1a den Bereich des Endusers (EN), mit einem Enduser Web-Windows (ENW) und/oder einem Enduser Smart-/Iphone (ENSI). Enduser Web-Windows (ENW) und Enduser Smart-/Iphone (ENSI) sind im Bereich des Endusers (EN) mit einem Vektor, Pixel und Informationskonverter (VPIkonf) verbunden, welcher mit einem im zentraler Rechnerbereich (ZR) angeordneten Modul Sicherheitslayer Web-Server (SWS) in Verbindung steht. Von einem im zentralen Rechnerbereich (ZR) angeordneten Applikations-, Rechte- und User- Server (ARU) werden über das Modul Sicherheitslayer Web-Server (SWS) die Programm- und Bildsteuerbefehle zum Enduser Web-Windows (ENW) und Enduser Smart-/Iphone (ENSI) übertragen (siehe punktierte Linie). Weiterhin werden die Zugriffsrechte vom im zentralen Rechnerbereich (ZR) angeordneten Modul Objekt-, Zugriffsrechte- und Datenbearbeitung (OZD) zu den beiden im zentralen Rechnerbereich (ZR) angeordneten Modulen Sicherheitslayer Web-Server (SWS) übertragen (siehe gestrichelte Linie). Die HTMI-, .png-, .dif- Daten und Zusatzinformationen werden direkt zwischen im zentraler Rechnerbereich (ZR) angeordneten Modul Sicherheitslayer Web-Server (SWS) und Enduser Web-Windows (ENW) und Enduser Smart-/Iphone (ENSI) übertragen, die.png-,.wca-, .dif- Daten und Zusatzinformationen werden über das im zentralen Rechnerbereich (ZR) angeordnete Modul Sicherheitslayer Web-Server (SWS) und den im Bereich des Endusers (EN) angeordneten Vektor, Pixel und Informationskonverter (VPIkonv) zu den Enduser Web-Windows (ENW) und Enduser Smart-/Iphone (ENSI) übertragen. Diese Daten werden im zentralen Rechnerbereich (ZR) von einer Verwaltung für Adress- und Infopunkte (VAI), dem Applikations-, Rechte- und User- Server (ARU) und dem Modul Objekt-, Zugriffsrechte- und Datenbearbeitung (OZD) generiert.

Weiterhin ist im zentralen Rechnerbereich (ZR) (siehe Fig. 1b oder Fig. 1c) ein Vektor, Pixel und Informationskonverter (VPIkonf) angeordnet, welcher einerseits mit dem Applikations-, Rechte- und User- Server (ARU) und andererseits mit einem Modul Datenbankserver-, Sicherheits- und Objektverwaltung (DBSO) verbunden ist. Im zentralen Rechnerbereich (ZR) steht die Datenbankserver-, Sicherheits- und Objektverwaltung (DBSO) mit dem Cloud-Archiv (CA) und deren Datenbanken DB mit den Pixelbilddatei (CPD), den CAD-Dateien (CVD) oder den Infopunkt-Informationen (CInf) sowie für die Zugriffrechte mit dem Applikations-, Rechte- und User- Server (ARU) und dem Modul Objekt-, Zugriffsrechte- und Datenbearbeitung (OZD) in Verbindung.

Mit .wca ist das Web 2D-CAD Austauschformat und mit .wcd ist das Web 3D-CAD Austauschformat für den Vektor-, Pixel- und Informationskonverter (VPIkonf) bezeichnet.

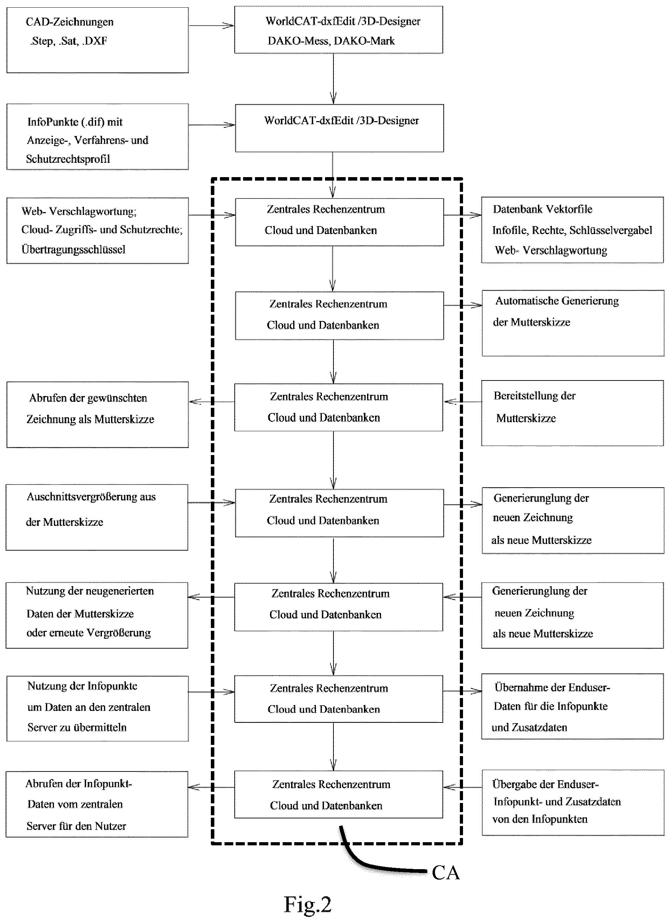

Fig. 2 zeigt den Ablaufplan des erfindungsgemäßen Verfahrens für die vorstehend beschriebene und in Fig. 1c dargestellte Vorrichtung, insbesondere für die automatische Generierung und Bereitstellung der Mutterskizze, für die Funktionen Datenbank Vektorfile, Infofile, Rechte, Schlüsselvergabe, Web-Verschlagwortung sowie die Generierung der neuen Zeichnung als neue Mutterskizze und die Übernahme der Enduser-Daten für die Infopunkte und Zusatzdaten.

Fig. 3 ein Beispiel für ein Mutterbild als Pixelgrafik. Dieses Mutterbild im Format .png hat beispielsweise eine Größe von 352 kbyte und eine Auflösung von 3840 x 2160 Pixel. Sie dient als erster Überblick (Gesamtbild) und soll dann wunschgemäß des Nutzers EN vergrößert werden können.

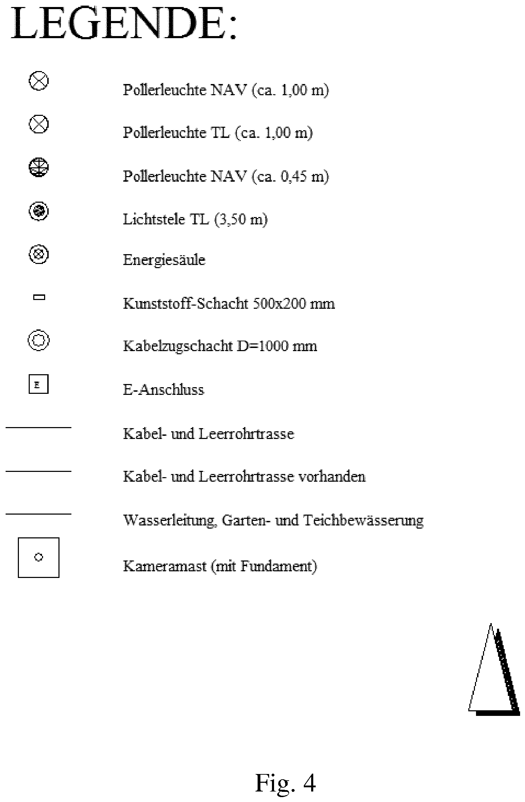

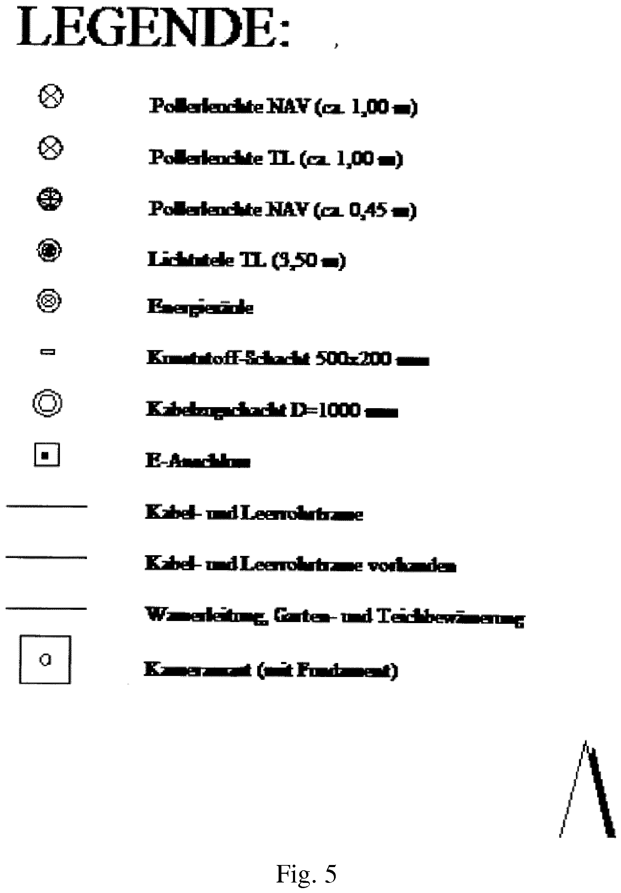

Fig. 4 zeigt ein Beispiel für einen Ausschnitt aus der Mutterskizze nach Fig. 3 als Vektorgrafik (d.h. einen Ausschnitt aus der .wca Vektorgrafikdatei <2kb entsprechend .png-Mutterskizzenausschnitt) und Fig. 5 zeigt denselben Ausschnitt als Pixelgrafik aus dem Mutterbild. Möchte man nun die Legende lesen und zoomt auf diese heran, erhält man einen Bildausschnitt des .png - Files, welcher schwer zu lesen ist (Stand der Technik).

Das erfindungsgemäße Verfahren zur Übertragung und Anzeige von Vektorgraphiken mit Zusatzinformationen aus einem cloudbasierten CAD-Archiv CA auf Mobilgeräten, tragbaren oder stationären Computern geht grundsätzlich von reinen CAD-Zeichnungen und dabei im Wesentlichen von dem gebräuchlichen 2D DXF-Austauschformat als Grundlage für die Anzeige der CAD-Datei in Echtzeit aus. GEO-Koordinaten und Navigationssystem Kartenmaterial werden nicht direkt als Basis für das erfindungsgemäße Verfahren primär genutzt.

Beispielsweise werden von den Liegenschaftsdiensten Auszüge aus Kartenmaterial als CAD-Vektordaten angeboten, auf diese bei Bedarf auch als DXF-Datei durch Rettungsdienste zugegriffen wird.

Dann ist aber aus dem Geo-Kartenmaterial bereits eine 2D-Vektorzeichnung als eindeutige CAD-Datei ohne direkten Bezug auf die einstigen Geo-Koordinaten entstanden. Für die Darstellung der Vektordaten in Echtzeit mit intelligenten Infopunkt-Informationen ist die Darstellung von reinen 2D-CAD-Daten im Maschinen- und Fahrzeugbau oder in Chemieanlagen von wesentlich größerer Bedeutung als die auch mögliche Anzeige von Flussverläufen mit den Beispiel von Slip-Stellen für die Wasserrettung und dem Technischen Hilfsdienst.

Wichtig ist beim erfindungsgemäßen Verfahren der Fakt, dass aus einer CAD-Datei Punkt-Koordinaten genutzt werden, um neben der CAD-Datei zusätzliche Informationen möglichst in Echtzeit auf unterschiedlichen Plattformen darstellen zu können. Dabei werden aus den CAD-Dateien für die schnelle Anzeige auf Endusergeräten Bilddateien im Pixelformat als Schwarz/Weiß-Zeichnungen generiert.

Durch Anzeigeprogramme werden zu diesen Zeichnungen über die Infopunktkoordinaten der ehemaligen CAD-Dateien die sich im Anzeigebild/-ausschnitt befindlichen Infopunkte auf die Schwarz/Weiß-Zeichnung mit den zugehörigen Anzeigeattributen der Infopunkte überlagert.

Im Vergleich zum Stand der Technik gibt es beim erfindungsgemäße Verfahren keine vorgebildeten Kacheln (wie bei Navigationssystemen üblich) und es wird auch nicht mit Renderingprozessoren gearbeitet, da ausschließlich nur mit echten CAD-Vektoren gearbeitet wird.

Es wird auch bei dem Beispiel Wasserrettung nicht erwartet, dass die Zeichnungen bis in jede Einzelheit der Realität als Geo-Daten entsprechen, da diese Daten nur Auskunft über die Anzahl der Technik und der geretteten Personen auf den 32 Slipstellen über eine Länge von 280km Auskunft geben soll. Es ist also im Hintergrund eine 2D S/W-Zeichnung (z.B. der Donau von Donaueschingen bis Passau) und die Infopunkte sind durch ihre Farbigkeit und Anzeigeattribute nur zur Informationsbereitstellung in Echtzeit notwendig. Werden gerettete Personen von der 17. Slip-Stelle durch den Technischen Hilfsdienst abgeholt, dann wird erwartet, dass die Reduzierung der Personen von z.B.100 auf 23 allen Rettern und der Einsatzleitung in wenigen Sekunden auf Ihren Stationär- und Mobilgeräten zur Verfügung steht.

Die Infopunkte (auch als Intelligente Infopunkte bezeichnet) sind durch folgende Merkmale gekennzeichnet, nämlich sie:
1. gehören zu einer Eigenschaftsgruppe
2. haben einen eineindeutigen Namen
3. haben Vektor- Koordinatenwerte (x,y,z)
4. haben Anzeigeattribute
5. haben Zugriffsrechte
6. besitzen ein oder mehrere Eigenschaftsparameter
7. Vektor- und Pixelkoordinaten in CAD- und Bilddateien sind bei Infopunkten gleichzeitig nutzbar.

Eigenschaftsgruppen von Intelligenten Infopunkten sind folgende:

### 1.1 Knoteninfopunkte (am intelligentesten)

Sind für CAD- Konstruktionszeichnungen in CAD-Dateien, Katalogen oder interaktiven Internetpräsentationen als intelligentes Mittel zur fehlerfreien Auswahl von Konstruktionselementen bestens geeignet.

Dies soll am Beispiel einer Verbindungselementegruppe verdeutlicht werden. Bei einer Schraube von 10mm Durchmesser und einer Schaftlänge von 40mm, werden diese Eigenschaften dem Knoteninfopunkt übergeben.

### 1.2. Befestigungsinfopunkt

Am Kopf der Schraube wird ein Befestigungsinfopunkt mit Lage- und Richtungsvektor gesetzt, und diese erhält einen

### 1.3. Stücklisteninfopunkt (auch BOM- Bill of Material genannt).

Sollen zwei 15mm Platten (ebenfalls mit eigenen Knoteninfopunkten) mit 10,2mm Bohrungen (ebenfalls mit eigenen Knoteninfopunkten) mit dieser Schraube verbunden werden, so ergibt die Prüfung der Knoteninfopunktparameter, dass die Bohrdurchmesser für diese Schraube geeignet sind. Durch die Positionierung der Schraube mit dem Befestigungsinfopunkt am Schraubenkopf mit dem Richtungsvektor in Richtung der übereinanderliegenden Bohrungen, erhält der Knoteninfopunkt der Schraube die Information, dass von der Schaftlänge der Schraube noch 10mm für weitere Befestigungselemente übrig sind.

Wird über den Konteninfopunkt der Schraube ein Verbindungselement gesucht, so werden nur Verbindungselemente mit 10mm Durchmesser für die weitere Verwendung angeboten. z.B. Muttern, Unterlegscheiben, Sicherungsringe, ... Nun wird eine Unterlegscheibe von 1,3mm Dicke und eine Mutter mit einer Dicke von 8mm ausgewählt. Die Überprüfung der restlichen Schaftlänge ergibt, dass diese Kombination geeignet ist.

Soll die normale Mutter aber gegen eine Kronenmutter mit einer Dicke von 13mm ausgetauscht werden, so ergibt die Schaftlängenprüfung, dass diese Verbindungselemente-Kombination in dieser Schaftlänge der Schraube nicht geeignet ist, da die Kronenmutter nicht vollständig aufgeschraubt werden kann und für eine Bohrung für die Anbringung eines Splintes nicht genügend Gewindelänge zur Verfügung steht.

Aus den Stücklisteninfopunkten (1.3. BOM) können alle Werte automatisch in die Stückliste der CAD-Zeichnung übernommen werden.

Knoteninfopunkte können nicht nur die Parameter für den Schraubendurchmesser, die Dicke und Schaftlänge, Materialeigenschaften, Festigkeit oder die Schüsselweite für den Sechskantkopf enthalten, sondern auch mögliche Lieferantenbestellnummern oder nur die DIN-, Afnor-, Gost-, ISO-, ISO-EN- Normbezeichnungen. Dies erleichtert die Arbeit zur Auswahl eines geeigneten Verbindungselementes für den Konstrukteur und den Materialbeschaffer stark und senkt Fehler bei der Auswahl und Materialbeschaffung erheblich.

Bei anderen Anwendungen können z.B.

### 1.4. Positionierungsinfopunkte

Auskunft darüber geben auf welcher Position ein Rettungsfahrzeug mit einer bestimmten Länge und Breite in welcher Richtung eingeparkt werden kann, damit er anderen Fahrzeugen nicht die Rettungsgasse versperrt und ein Optimum für die Parkfläche eines Sammelraumes im Katastrophenfall zur Verfügung steht. Positionierungsinfopunkte können weiterhin in Echtzeit darüber Auskunft geben wie viele gerettete Personen sich zeitnah auf einem Sammelpunkt befinden.

Wenn die maximale Kapazität eines Sammelpunktes 100 Personen umfasst, so können für diesen Positionierungsinfopunkt die Anzahl der anwesenden Personen mit dem Durchmesser der Anzeige, der Farbe und "Blinken" des Infopunktes verknüpft werden.

Wenn bei 20 und 80 Personen Triggerpunkte gesetzt werden, so kann dieser Positionierungsinfopunkt bei 1- 19 Personen "klein" und "Grün", bei 20 -79 Personen "mittel" und "Gelb" und bei 80 bis 100 Personen "groß", "blinkend" und "Rot" gesetzt werden.

### 1.5. Registrierungsinfopunkte

können optimal darüber Auskunft geben, an welchem Punkt in einem Raum oder Objekt sich bestimmte Gegenstände in welchem Zustand und mit welchen Eigenschaften befinden. Es kann sich um unterschiedliche Typen von Feuerlöschern, Druckern, Hilfsmitteln, Technikfahrzeugen, Maschinen, Ausrüstungen oder sonstigen beweglichen Gegenständen handeln. z.B.
auf Großbaustellen - Wo befinden sich an welchen Gebäudeteilen Aufzüge mit welcher Traglast oder wo befinden sich intakte Kreissägen mit welchem Sägeblattdurchmesser.

In Hotels - Welche Zimmer an welcher Position und Etage sind Frei (Grün), Vorbestellt (Gelb), nicht Gereinigt (Lila) oder Belegt (Rot).

Bei Autovermietungen oder Werkstattgruppen - In welcher Stadt oder an welchem Standort sind wieviel Fahrzeuge z.B. sofort verfügbar/fertig repariert, abgegebene / nicht gereinigte oder ausgelieferte Fahrzeuge und wo stehen diese Fahrzeuge mit welchem KFZ-Kennzeichen.

### 1.6. Neue Infopunkteigenschaftsgruppen

Bei der Nutzung von Eigenschaftsgruppen können Gruppen durch Hinzufügen oder Löschen von Parametern verändert werden. Es können aber aus den bestehenden Infopunktgruppen auch neue Gruppen mit individuell angepassten eigenen Parametern gebildet werden.

### 2. Eineindeutiger Namen

der Infopunktname kann automatisch vergeben werden oder es wird von einer Person diesem Infopunkt ein "sprechender Name" z.B. "Feuerwehr - J-XY 26" zugeordnet.

### 3. Vektor- Koordinatenwerte (x, y, z)

in den CAD- Zeichnungen erhalten alle Infopunkte durch ihre Positionierung in allen drei Richtungen entsprechende Koordinatenwerte. Wird nur eine zweidimensionale CAD-Zeichnung verwendet, so wird die Z- Koordinate auf den Wert "Null" gesetzt.

### 4. Anzeigeattribute

Jeder Infopunkt hat Anzeigeattribute, ob er sichtbar sein soll, in welcher Farbe, blinkend oder Größe er dargestellt werden soll, ob er Triggerpunkte erhalten hat oder ob er dynamisch seine Größe entsprechend eines Parameters ändern darf.

### 5. Zugriffsrechte

Jeder Infopunkt hat für bestimmte festgelegte Nutzergruppen eine Zugriffsrechtetabelle. Diese legt fest, ob ein Nutzer aus einer Nutzergruppe an welchem Parameter Veränderungen vornehmen darf, ob ein Parameter für diese Nutzergruppe sichtbar ist oder ob der ganze Infopunkt überhaupt angezeigt werden darf.

### 6. Infopunkte besitzen ein oder mehrere Eigenschaftsparameter

Eigenschaftsparameter können:
- Eingabewerte als Anzeigeattribute zugewiesen werden
- eine beliebige Anzahl von Triggerpunkten zugewiesen bekommen
- Grenzwerte erhalten
- auf feste Eigenschaften eingeschränkt werden
- alphanumerische und/oder numerische Inhalte zugewiesen bekommen

### 7. Infopunktekoordinaten

Die Infopunkte sind primär den CAD- Vektordaten zugeordnet und in der CAD-Datei gespeichert. Die Eigenschaften und Steuerparameter des Infopunktes werden aber neben dem CAD- System und seiner erzeugten CAD-Datei in einer eigenständigen Datei mit einer Referenzierung zum CAD Infopunkt abgelegt.

Die Anzeigebilder für das Bildformat werden durch Koordinatentransformation von Vektorkoordinaten in Pixelkoordinaten für das Internet, Anzeigegeräte, Plotter oder Drucker umgewandelt und als eigenständige Dateien temporär abgelegt.

Neben diesen Bilddateien werden referenzierte Infopunktdateien für die gleichzeitige Nutzung in Vektor- oder Pixeldateiformaten zeitnah bereitgestellt.

Anzeigeprogramme fügen diese zusammengehörenden Informationen in Echtzeit zu einer Anzeigedatei zusammen und übergeben diese den aufrufenden Programmmodulen.

Die Erfindung ist nicht auf die dargestellten und beschriebenen Ausführungsbeispiele beschränkt, sondern umfasst auch alle im Sinne der Erfindung gleichwirkenden Ausführungen.

Im Rahmen der Erfindung kann eine direkte Speicherung der Infopunktinformationen in die CAD-Datei (Mutterskizze) im Cloud-Archiv (CA) vorgesehen werden.

### Bezugszeichenliste:

- CA: Cloud-Archiv
- CInf: Infopunkte-Dateien
- CPD: komprimierte Pixelgrafikdatei
- CVD: nutzereigene Vektorgraphiken
- EN: Enduser
- N: Nutzer
- ZR: zentraler Rechnerbereich
- CHS: CAD- Hybrid System (Vektor/Pixel)
- CDS: CAD- Digitalisier System
- ENW: Enduser Web-Windows
- ENSI: Enduser Smart-/Iphone
- VPIkonf: Vektor, Pixel und Informationskonverter
- WEB E+I: Web-Daten Export und Import
- .wca: Web 2D-CAD Austauschformat für VPIkonv
- .wcd: Web 3D-CAD Austauschformat für VPIkonv
- SWS: Sicherheitslayer Web-Server
- OZD: Objekt-, Zugriffsrechte- und Datenbearbeitung
- ARU: Applikations-, Rechte- und User- Server
- VAI: Verwaltung für Adress- und Infopunkte
- DBSO: Datenbankserver-, Sicherheits- und Objektverwaltung
- UD: User-Daten
- URD: User-Rechtedaten
- ZD: Zugriffs-Daten

## Patentansprüche

1. Verfahren zur Übertragung und Anzeige von Vektorgraphiken mit Zusatzinformationen
aus einem cloudbasierten CAD-Archiv (CA),
wobei die Übertragung aus dem cloudbasierten CAD-Archiv (CA) auf Mobilgeräte, tragbare oder stationäre Computer von Endnutzern (EN) zur Anzeige auf einer App auf den Frontends der Mobilgeräte, tragbaren oder stationären Computer durchgeführt wird,
wobei das Verfahren die folgenden Schritte umfasst:
von Nutzern (N) werden CAD-Dateien (CVD) für das Cloud-Archiv (CA) bereitgestellt
die einzelnen bereitgestellten CAD-Dateien (CVD) werden vor der Aufbereitung für das CAD-Archiv (CA) auf Viren-, Konsistenz und Fehlerfreiheit geprüft,
nach erfolgreicher Prüfung wird zu jeder einzelnen nutzereigenen CAD-Datei (CVD) eine komprimierte Pixelgrafikdatei (CPG) erstellt und die Dateien werden gemeinsam mit einer oder mehreren Infopunkte-Dateien mit Infopunkten (CInf) als Zusatzinformationen verschlüsselt und in dem CAD-Archiv (CA) eingespeichert, wobei der Nutzer (N) für Endnutzergruppen Passwörter und Zugriffsrechte für die einzelnen CAD-Daten (CVG) oder Infopunkt-Informationen der Infopunkte (CInf) im CAD-Archiv (CA) festlegen kann,
durch einen Endnutzer (EN) abgerufene Daten werden aus dem CAD-Archiv (CA) verschlüsselt und komprimiert zur App auf dem Mobilgerät, tragbaren oder stationären Computer des Endnutzers (EN) übertragen, wobei die Eigenschaften für die Infopunkte und Zusatzinformationen der Infopunkte (CInf) erst mittels der App auf dem Mobilgerät, tragbaren oder stationären Computer endnutzerabhängig angezeigt werden, derart, dass die Infopunkte (CInf) lagegenau in den Vektor- und Pixelgrafiken durch die (xv, yv, zv)- und (xp, yp, zp)-Koordinaten den CAD-Dateien (CVD) und Pixelgrafikdateien (CPD) zugeordnet werden.

2. Verfahren nach Anspruch 1, **dadurch gekennzeichnet, dass** der Dateinamen der nutzereigenen Pixelgrafikdatei (CPD) mindestens eine Nutzeridentifikation, das Datum und die Uhrzeit der ersten Einspeicherung, eine Kennung für 2D- CAD-Daten oder 3D- CAD-Daten, eine Versionsnummer und eine CAD-System - oder Austauschformat-Kennung aufweist.

3. Verfahren nach Anspruch 2, **dadurch gekennzeichnet, dass** der Dateinamen der nutzereigenen CAD-Datei (CVD) um Erweiterungen hinsichtlich der Bildgröße des Gesamtbildes und des Bildausschnitt mit horizontalen und vertikalen Anfangspunkt und einem Datei-Suffix ".png" ergänzt wird.

4. Verfahren nach einem oder mehreren der Ansprüche 1 bis 3, **dadurch gekennzeichnet, dass** für intelligente Infopunkte (CInf) der Dateinamen durch eine Dateiartkennung für Text gefolgt von einer fortlaufenden Nummer und einem Datei-Suffix ".dif" ergänzt wird.

5. Verfahren nach einem oder mehreren der Ansprüche 1 bis 4, **dadurch gekennzeichnet, dass** unter Beachtung von Zugriffsrechten Ausschnittvergrößerungen und Zuordnung der intelligenten Infopunkte (CInf) bei grafischen Daten in einem Ausschnittfenster durch eine App auf den Mobilgeräten, tragbaren oder stationären Computern über die Infopunktkoordinaten erfolgt, derart, dass das Ausschnittfenster detailgetreu mit hoher Auflösung auf Mobilgeräten, tragbaren oder stationären Computern zusammen mit einer aktuellen Information angezeigt wird.

6. Verfahren nach einem oder mehreren der Ansprüche 1 bis 5, **dadurch gekennzeichnet, dass** der Enduser (EN) nur die Möglichkeit hat, die Eigenschaften und Zusatzinformationen der intelligenten Infopunkte (CInf) im cloudbasierten CAD-Archiv (CA) bei entsprechender Freigabe des Nutzers (N) zu verändern und dass damit in Echtzeit Eigenschaften der intelligenten Infopunkte (CInf) und Zusatzinformationen für nachfolgende Enduser (EN) nutzbar gemacht werden, ohne die originalen nutzereigenen Vektorgrafiken (CVD) oder Pixelgrafiken (CPD) zu verändern.

7. Verfahren nach einem oder mehreren der Ansprüche 1 bis 6, **dadurch gekennzeichnet, dass** die intelligente Infopunkte (CInf) durch die Merkmale:
1. gehören zu einer Eigenschaftsgruppe
2. haben einen eineindeutigen Namen
3. haben Vektor- Koordinatenwerte (xv, yv, zv)
4. haben Anzeigeattribute
5. haben Zugriffsrechte
6. besitzen ein oder mehrere Eigenschaftsparameter
7. Vektor- (xv, yv, zv) und Pixelkoordinaten (xp, yp, zp) in CAD- (CVD) und Pixelgrafikdateien (CPD) sind gleichzeitig nutzbar gekennzeichnet sind.

8. Verfahren nach einem oder mehreren der Ansprüche 1 bis 7, **dadurch gekennzeichnet, dass** die Eigenschaftsgruppen der intelligenten Infopunkte (CInf) wie folgt eingeteilt sind: 1.1 Knoteninfopunkte
1.2 Befestigungsinfopunkte
1.3 Stücklisteninfopunkte
1.4. Positionierungsinfopunkte
1.5. Registrierungsinfopunkte
1.6. Neue Infopunkteigenschaftsgruppen

9. Verfahren nach einem oder mehreren der Ansprüche 1 bis 8, bei dem der jeweilige Infopunktnamen der intelligenten Infopunkte (CInt) automatisch vergeben wird oder es wird von einer Person diesem intelligenten Infopunkt (CInt) ein sprechbarer Name zugeordnet.

10. Verfahren nach einem oder mehreren der Ansprüche 1 bis 9, **dadurch gekennzeichnet, dass** im Fall von CAD- Zeichnungen alle intelligenten Infopunkte (CInt) durch ihre Positionierung in allen drei Richtungen entsprechende Koordinatenwerte erhalten und falls nur eine zweidimensionale CAD-Zeichnung verwendet wird, so wird die Z- Koordinate auf den Wert "Null" gesetzt.

11. Verfahren nach einem oder mehreren der Ansprüche 1 bis 10, **dadurch gekennzeichnet, dass** jeder intelligente Infopunkt (CInf) Anzeigeattribute hat, ob er sichtbar sein soll, in welcher Farbe, blinkend oder Größe er dargestellt werden soll, ob er Triggerpunkte erhalten hat oder ob seine Größe entsprechend eines Parameters geändert werden darf.

12. Verfahren nach einem oder mehreren der Ansprüche 1 bis 11, **dadurch gekennzeichnet, dass** jeder intelligente Infopunkt (CInf) für bestimmte festgelegte Nutzergruppen eine Zugriffsrechtetabelle hat, welche festlegt, ob ein Nutzer aus einer Nutzergruppe an einem Parameter Veränderungen vornehmen darf, ob ein Parameter für diese Nutzergruppe sichtbar ist oder ob der ganze Infopunkt überhaupt angezeigt werden darf.

13. Verfahren nach einem oder mehreren der Ansprüche 1 bis 12, **dadurch gekennzeichnet, dass** intelligente Infopunkte (CInf) ein oder mehrere Eigenschaftsparameter besitzen, indem
- Eingabewerte als Anzeigeattribute zugewiesen werden.
- diese eine beliebige Anzahl von Triggerpunkten zugewiesen bekommen.
- diese Grenzwerte erhalten.
- diese auf festlegbare Eigenschaften eingeschränkt werden.
- diese alphanumerische und/oder numerische Inhalte zugewiesen bekommen.

14. Verfahren nach einem oder mehreren der Ansprüche 1 bis 13, **dadurch gekennzeichnet, dass** die intelligenten Infopunkte (CInf) den CAD-Vektordaten (CVG) zugeordnet und in der CAD-Datei (CVD) gespeichert sind, dass zusätzlich die Eigenschaften und Steuerparameter des Infopunkts in einer eigenständigen Datei mit einer Referenzierung zum intelligenten CAD Infopunkt (CInf) abgelegt werden, dass Anzeigebilder im Bildformat durch Koordinatentransformation von Vektorkoordinaten in Pixelkoordinaten für das Internet, Anzeigegeräte, Plotter oder Drucker umgewandelt und als eigenständige Dateien temporär abgelegt werden, dass neben diesen Bilddateien referenzierte Infopunktdateien für die gleichzeitige Nutzung in Vektor- oder Pixeldateiformaten zeitnah bereitgestellt werden und dass Anzeigeprogramme diese zusammengehörenden Informationen in Echtzeit zu einer Anzeigedatei zusammenfügen und diese an aufrufende Programmmodule übergeben.

15. Vorrichtung zur Übertragung und Anzeige von Vektorgraphiken mit Zusatzinformationen aus einem cloudbasierten CAD-Archiv (CA) auf Mobilgeräten, tragbaren oder stationären Computern, die konfiguriert ist, das Verfahren gemäß einem der Ansprüche 1-14 auszuführen.

## Claims

1. Method for transferring and displaying vector graphics with additional information from a cloud-based CAD archive (CA), whereby the transfer from the cloud-based CAD archive (CA) to mobile devices, portable or stationary computers of end users (EN) for displaying on an app on the front-ends of the mobile devices, portable or stationary computers, the method comprising the following steps:
- CAD files (CVD) for the cloud archive (CA) are provided by users (N).
- the individually provided CAD files (CVD) are checked for viruses, consistency and errors before processing for the CAD archive (CA),
- after a successful check, a compressed pixel graphic file (CPG) is created for each individual user-specific CAD file (CVD) and the files are encrypted together with one or more info point files with info points (CInf) as additional information and stored in the CAD archive (CA ) stored, whereby the user (N) can define passwords and access rights for the individual CAD data (CVG) or info point information of the info points (CInf) in the CAD archive (CA) for end user groups,
- data retrieved by an end user (EN) is transmitted from the CAD archive (CA) encrypted and compressed to the app on the mobile device, portable or stationary computer of the end user (EN), whereby the properties for the info points and additional information of the info points (CInf) are only displayed using the app on the mobile device, portable or stationary computer, depending on the end user, in such a way that the info points (CInf) are positioned precisely in the vector and pixel graphics by the (xv, yv, zv) and (xp, yp, zp) - coordinates which are assigned to the CAD files (CVD) and pixel graphics files (CPD).

2. The method according to claim 1, **characterized in that** the file name of the user's own pixel graphics file (CPD) contains at least one user identification, the date and time of the first storage, an identifier for 2D CAD data or 3D CAD data, a version number and has a CAD system or exchange format identifier.

3. The method according to claim 2, **characterized in that** the file name of the user's own CAD file (CVD) is supplemented with extensions regarding the image size of the overall image and the image section with horizontal and vertical starting points and a file suffix ".png".

4. The method according to one or more of claims 1 to 3, **characterized in that** for intelligent info points (CInf) the file name is supplemented by a file type identifier for text or database followed by a sequential number and a file suffix ".dif".

5. The method according to one or more of claims 1 to 4, **characterized in that,** taking into account access rights, section enlargements and assignment of the intelligent info points (CInf) for graphic data in a section window by an app on the mobile devices, portable or stationary computers via the info point coordinates takes place in such a way that the clipping window is displayed in detail with high resolution on mobile devices, portable or stationary computers together with up-to-date information.

6. The method according to one or more of claims 1 to 5, **characterized in that** the end user (EN) only has the option of changing the properties and additional information of the intelligent info points (CInf) in the cloud-based CAD archive (CA) with appropriate approval by the user and that properties of the intelligent info points (CInf) and additional information can be made usable in real time for subsequent end users (EN) without changing the original user-specific vector graphics (CVD) or pixel graphics (CPD).

7. The method according to one or more of claims 1 to 6, **characterized in that** the intelligent information points (CInf) are marked by the features:
1. belong to a property group
2. have a unique name
3. have vector coordinate values (xv, yv, zv)
4. have display attributes
5. have access rights
6. have one or more property parameters
7. Vector (xv, yv, zv) and pixel coordinates (xp, yp, zp) in CAD (CVD) and pixel graphic (CPD) files can be used simultaneously.

8. The method according to one or more of claims 1 to 7, **characterized in that** the property groups of the intelligent information points (CInf) are classified according to their intelligence as follows:
1.1 junction info points
1.2 fastening information points
1.3 parts list info points
1.4. positioning info points
1.5. registration info points
1.6. new info point property groups.

9. The method as claimed in one or more of claims 1 to 8, **in which** the respective info point name of the intelligent info points (CInf) is assigned automatically or a pronounceable name is assigned to this intelligent info point (CInf) by a person.

10. The method according to one or more of claims 1 to 9, **characterized in that** in the case of CAD drawings all intelligent info points (CInf) receive corresponding coordinate values through their positioning in all three directions and if only a two-dimensional CAD drawing is used, the Z coordinate is set to the value "zero".

11. The method according to one or more of claims 1 to 10, **characterized in that** each intelligent info point (CInf) has display attributes, whether it should be visible, in which color, flashing or size it should be displayed, whether it has received trigger points or whether it can be dynamically resized according to a parameter.

12. The method according to one or more of claims 1 to 11, **characterized in that** each intelligent information point (CInf) for certain defined user groups has an access rights table which determines whether a user from a user group may make changes to a parameter, whether a parameter is visible for this user group or whether the entire info point may be displayed at all.

13. The method according to one or more of claims 1 to 12, **characterized in that** intelligent info point (CInf) have one or more property parameters by
- input values are assigned as display attributes.
- display attributes assigned any number of trigger points.
- trigger points get these limits.
- these limits are restricted to definable properties.
- definable properties are assigned alphanumeric and/or numeric content.

14. The method according to one or more of claims 1 to 13, **characterized in that** the intelligent info points (CInf) are assigned to the CAD vector data (CVG) and stored in the CAD file (CVD), that the properties and control parameters of the info point can be stored in an independent file with a reference to the intelligent CAD info point (CInf), that display images in image format are converted by coordinate transformation from vector coordinates into pixel coordinates for the Internet, display devices, plotters or printers and are temporarily stored as independent files, that next to these image files referenced info point files are made available promptly for simultaneous use in vector or pixel file formats and that display programs combine this related information in real time into a display file and transfer it to the calling program modules.

15. Device for the transmission and display of vector graphics with additional information from a cloud-based CAD archive (CA) on mobile devices, portable or stationary computers, which is configured to carry out the method according to any one of claims 1-14.

## Revendications

1. Procédé de transfert et d'affichage de graphiques vectoriels avec des informations supplémentaires à partir d'une archive CAO (CA) basée sur le cloud, dans lequel le transfert de l'archive CAO (CA) basée sur le cloud vers des appareils mobiles, des ordinateurs portables ou fixes d'utilisateurs finaux (EN) pour l'affichage sur une application sur les frontaux des appareils mobiles, ordinateurs portables ou fixes, le procédé comprenant les étapes suivantes :
- les fichiers CAO (CVD) pour l'archive cloud (CA) sont fournis par les utilisateurs (N).
- les fichiers CAO (CVD) fournis individuellement sont vérifiés pour les virus, la cohérence et les erreurs avant le traitement pour l'archive CAO (CA),
- après une vérification réussie, un fichier graphique pixel compressé (CPG) est créé pour chaque fichier CAO (CVD) spécifique à l'utilisateur et les fichiers sont cryptés avec un ou plusieurs fichiers de points d'information avec des points d'information (CInf) comme informations supplémentaires et stocké dans l'archive CAO (CA ) stocké, dans lequel l'utilisateur (N) peut définir des mots de passe et des droits d'accès pour les données CAO (CVG) individuelles ou les informations de point d'information des points d'information (CInf) dans l'archive CAO (CA) pour la fin groupes d'utilisateurs,
- les données récupérées par un utilisateur final (EN) sont transmises de l'archive CAO (CA) cryptées et compressées à l'application sur l'appareil mobile, l'ordinateur portable ou fixe de l'utilisateur final (EN), les propriétés des points d'information et les informations supplémentaires des points d'information (CInf ) ne sont affichées qu'à l'aide de l'application sur l'appareil mobile, l'ordinateur portable ou fixe, selon l'utilisateur final, de manière à ce que les points d'information (CInf) soient positionnés avec précision dans le vecteur et le pixel graphiques par les coordonnées (xv, yv, zv) et (xp, yp, zp) qui sont attribuées aux fichiers CAO (CVD) et aux fichiers graphiques pixel (CPD).

2. Procédé selon la revendication 1, **caractérisé en ce que** le nom de fichier du propre fichier graphique pixel (CPD) de l'utilisateur contient au moins une identification de l'utilisateur, la date et l'heure du premier stockage, un identifiant pour les données CAO 2D ou CAO 3D données, un numéro de version et possède un système CAO ou un identifiant de format d'échange.

3. Procédé selon la revendication 2, **caractérisé en ce que** le nom de fichier du propre fichier CAO (CVD) de l'utilisateur est complété par des extensions concernant la taille d'image de l'image globale et la section d'image avec des points de départ horizontaux et verticaux et un suffixe de fichier ".png".

4. Procédé selon une ou plusieurs des revendications 1 à 3, **caractérisé en ce que** pour les points d'information intelligents (CInf), le nom de fichier est complété par un identifiant de type de fichier pour texte ou base de données suivi d'un numéro séquentiel et d'un suffixe de fichier ".dif".

5. Procédé selon une ou plusieurs des revendications 1 à 4, **caractérisé en ce que,** compte tenu des droits d'accès, des agrandissements de section et de l'attribution des points d'information intelligents (CInf) pour les données graphiques dans une fenêtre de section par une application sur le mobile appareils mobiles, ordinateurs portables ou fixes via les coordonnées du point d'information se fait de telle manière que la fenêtre de découpage est affichée en détail avec une haute résolution sur les appareils mobiles, les ordinateurs portables ou fixes avec des informations à jour.

6. Procédé selon une ou plusieurs des revendications 1 à 5, **caractérisé en ce que** l'utilisateur final (EN) a uniquement la possibilité de modifier les propriétés et les informations supplémentaires des points d'information intelligents (CInf) dans l'archive CAO basée sur le cloud (CA) avec l'approbation appropriée de l'utilisateur et que les propriétés des points d'information intelligents (CInf) et des informations supplémentaires peuvent être rendues utilisables en temps réel pour les utilisateurs finaux ultérieurs (EN) sans modifier les graphiques vectoriels spécifiques à l'utilisateur (CVD) ou les graphiques en pixels d'origine (CPD).

7. Procédé selon une ou plusieurs des revendications 1 à 6, **caractérisé en ce que** les points d'information intelligents (CInf) sont marqués par les caractéristiques:
1. appartenir à un ensemble immobilier
2. avoir un nom unique
3. avoir des valeurs de coordonnées vectorielles (xv, yv, zv)
4. avoir des attributs d'affichage
5. avoir des droits d'accès
6. avoir un ou plusieurs paramètres de propriété
7. les coordonnées vectorielles (xv, yv, zv) et pixel (xp, yp, zp) dans les fichiers CAO (CVD) et pixel graphique (CPD) peuvent être utilisées simultanément.

8. Procédé selon une ou plusieurs des revendications 1 à 7, **caractérisé en ce que** les groupes de propriétés des points d'information intelligents (CInf) sont classés selon leur intelligence comme suit :
1.1 points d'information de jonction
1.2 points d'information de fixation
1.3 points d'information de la liste des pièces
1.4. points d'information de positionnement
1.5. points d'information sur l'inscription
1.6. nouveaux groupes de propriétés de points d'information.

9. Procédé selon une ou plusieurs des revendications 1 à 8, **dans lequel** le nom de point d'information respectif des points d'information intelligents (CInf) est attribué automatiquement ou un nom prononçable est attribué à ce point d'information intelligent (CInf) par un personne.

10. Procédé selon une ou plusieurs des revendications 1 à 9, **caractérisé en ce que** dans le cas de dessins CAO, tous les points d'information intelligents (CInf) reçoivent des valeurs de coordonnées correspondantes par leur positionnement dans les trois directions et si seulement un CAO bidimensionnel dessin est utilisé, la coordonnée Z est définie sur la valeur "zéro".

11. Procédé selon une ou plusieurs des revendications 1 à 10, **caractérisé en ce que** chaque point d'information intelligent (CInf) à des attributs d'affichage, s'il doit être visible, dans quelle couleur, clignotement ou taille il doit être affiché, s'il a points de déclenchement reçus ou s'il peut être redimensionné dynamiquement en fonction d'un paramètre.

12. Procédé selon une ou plusieurs des revendications 1 à 11, **caractérisé en ce que** chaque point d'information intelligent (CInf) pour certains groupes d'utilisateurs définis possède une table de droits d'accès qui détermine si un utilisateur d'un groupe d'utilisateurs peut modifier un paramètre, si un paramètre est visible pour ce groupe d'utilisateurs ou si tout le point d'information peut être affiché.

13. Procédé selon une ou plusieurs des revendications 1 à 12, **caractérisé en ce que** le point d'information intelligent (CInf) possède un ou plusieurs paramètres de propriété par
- les valeurs d'entrée sont affectées en tant qu'attributs d'affichage.
- afficher les attributs attribués à un nombre quelconque de points de déclenchement.
- les points de déclenchement obtiennent ces limites.
- ces limites sont limitées à des propriétés définissables.
- les propriétés définissables se voient attribuer un contenu alphanumérique et/ou numérique.

14. Procédé selon une ou plusieurs des revendications 1 à 13, **caractérisé en ce que** les points d'information intelligents (CInf) sont affectés aux données vectorielles CAO (CVG) et stockés dans le fichier CAO (CVD), que les propriétés et le contrôle les paramètres du point d'information peuvent être stockés dans un fichier indépendant avec une référence au point d'information CAO intelligent (CInf), que affiche les images au format image sont converties par transformation de coordonnées de coordonnées vectorielles en coordonnées de pixels pour Internet, dispositifs d'affichage, traceurs ou des imprimantes et sont temporairement stockés sous forme de fichiers indépendants, qu'à côté de ces fichiers d'images, des fichiers de points d'information référencés sont rapidement mis à disposition pour une utilisation simultanée dans des formats de fichiers vectoriels ou pixel et que les programmes d'affichage combinent ces informations connexes en temps réel dans un fichier d'affichage et les transferts aux modules du programme appelant.

15. Dispositif pour la transmission et l'affichage de graphiques vectoriels avec des informations supplémentaires à partir d'une archive CAO (CA) basée sur le cloud (CA) sur des appareils mobiles, des ordinateurs portables ou fixes, qui est configuré pour mettre en oeuvre le procédé selon l'une quelconque des revendications 1 à 14.
